# EUROPEAN PATENT APPLICATION

(11) **EP 4 794 472 A1**
(43) Date of publication of application: **19.08.2026**
(21) Application number: 25207276.4
(22) Date of filing: 07.10.2025
(51) Int. Cl.: H10D 30/01, H10D 30/66, H10D 62/10, H10D 64/27, H10D 62/832, H10D 64/68

(54) **SEMICONDUCTOR DEVICE**

(30) Priority: 12.02.2025 KR 20250018308
(71) Applicant: Samsung Electronics Co., Ltd., Suwon-si, Gyeonggi-do 16677 (KR)
(72) Inventor: KIM, Taehun, Suwon-si (KR); MOON, Jeongje, Suwon-si (KR); PARK, Young Hwan, Suwon-si (KR); PARK, Jeonghwan, Suwon-si (KR); OH, Sewoong, Suwon-si (KR); WOO, Sangsu, Suwon-si (KR)
(74) Representative: Marks & Clerk LLP

(57) **Abstract**

A semiconductor device includes a substrate, a first conductivity type semiconductor layer on a first surface of the substrate and penetrated by a first trench and a second trench, a gate electrode in the first trench and including a first side surface and a second side surface opposing each other, a first gate insulating layer on the first side surface and a lower surface of the gate electrode, a second conductivity type doping layer on the first conductivity type semiconductor layer and covering a portion of a side surface of the first gate insulating layer, a first conductivity type doped region on the second conductivity type doping layer and covering another portion of the side surface of the first gate insulating layer, a source electrode on the first conductivity type doped region, a drain electrode on a second surface of the substrate and a shielding pattern around the second trench.

## Description

### BACKGROUND OF THE DISCLOSURE

### 1. Field of the Disclosure

The present disclosure relates to a semiconductor device. Specifically, the present disclosure relates to a semiconductor device comprising a transistor, such as a metal-oxide-semiconductor field effect transistor (MOSFET). For instance, the semiconductor device may comprise a power MOSFET.

### 2. Description of the Related Art

In modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-power electronic devices. Power semiconductor devices have the ability to handle high power and durability, so they can handle large amounts of current and withstand high voltages. For example, power semiconductor devices can handle voltages from hundreds to thousands of volts and currents from tens to thousands of amperes. Power semiconductor devices may improve the efficiency of electrical energy by minimizing power loss. In addition, power semiconductor devices may be operated stably even in environments such as high temperatures.

These power semiconductor devices may be classified by material, for example, there are SiC power semiconductor devices and GaN power semiconductor devices. By manufacturing power semiconductor devices using SiC or GaN instead of existing silicon wafers (Si wafers), the shortcomings of silicon, which has unstable characteristics at high temperatures, may be complemented. SiC power semiconductor devices are resistant to high temperatures and have low power loss, making them suitable for electric vehicles and renewable energy systems. GaN power semiconductor devices are expensive but efficient in terms of speed, making them suitable for fast charging of mobile devices.

### SUMMARY

The embodiments are directed to providing a semiconductor device with improved reliability.

A semiconductor device according to an embodiment includes a substrate, a first conductivity type semiconductor layer on a first surface of the substrate and including a first trench and a second trench overlapping the first trench, the second trench being positioned at one side of the first trench, and the first trench and the second trench each penetrating in the first conductivity type semiconductor layer, a gate electrode in the first trench and including a first side surface and a second side surface opposing the first side surface, a first gate insulating layer on the first side surface and a lower surface of the gate electrode, a second conductivity type doping layer on the first conductivity type semiconductor layer and covering at least a portion of a side surface of the first gate insulating layer, a first conductivity type doped region on the second conductivity type doping layer and covering at least another portion of the side surface of the first gate insulating layer, a source electrode on the first conductivity type doped region, a drain electrode on a second surface of the substrate and a shielding pattern around the second trench.

A semiconductor device according to an embodiment includes a substrate, a first conductivity type semiconductor layer on a first surface of the substrate and including a first trench and a second trench overlapping the first trench, the second trench being positioned at one side of the first trench, and the first trench and the second trench each penetrating in the first conductivity type semiconductor layer, a gate electrode in the first trench and including a first side surface and a second side surface opposing the first side surface, a first gate insulating layer on the first side surface and a lower surface of the gate electrode, a second conductivity type doping layer on the first conductivity type semiconductor layer and covering at least a portion of a side surface of the first gate insulating layer, a first conductivity type doped region on the second conductivity type doping layer and covering at least another portion of the side surface of the first gate insulating layer, a source electrode on the first conductivity type doped region, a drain electrode on a second surface of the substrate, an internal insulating pattern in the second trench. A bottom surface of the second trench is positioned closer to the drain electrode than a bottom surface of the first trench and wherein the internal insulating pattern comprises silicon oxide (SiO₂).

A semiconductor device according to an embodiment includes a substrate, a first conductivity type semiconductor layer on a first surface of the substrate, a first trench and a second trench overlapping the first trench, the second trench being positioned at one side of the first trench, and the first trench and the second trench each penetrating in the first conductivity type semiconductor layer, a gate electrode in the first trench and including a first side surface and a second side surface opposing the first side surface, a first gate insulating layer conformally on a bottom surface of the first trench, and on a side surface of the first trench facing the first side surface of the gate electrode, an internal insulating pattern in the second trench having an upper surface at a same level as an upper surface of the gate electrode, a capping layer covering the upper surface of the gate electrode and the internal insulating pattern, a second conductivity type doping layer on the first conductivity type semiconductor layer and covering at least a portion of a side surface of the first gate insulating layer and a portion of a side surface of the internal insulating pattern, a first conductivity type doped region on the second conductivity type doping layer and covering at least another portion of the side surface of the first gate insulating layer, a second conductivity type doped region on the second conductivity type doping layer and covering at least a portion of the side surface of the internal insulating pattern, a source electrode covering at least a portion of an upper surface of the first conductivity type doped region, an upper surface of the second conductivity type doped region, an upper surface of the internal insulating pattern, and an upper surface and a side surface of the capping layer, a drain electrode on a second surface of the substrate, and a shielding pattern surrounding at least a portion of a side surface and a lower surface of the internal insulating pattern. At least a portion of a lower surface of the first gate insulating layer and a lower surface of the second conductivity type doped region are in contact with the shielding pattern, and the internal insulating pattern comprises silicon oxide (SiO₂).

According to embodiments, a semiconductor device with improved reliability may be provided.

At least some of the above and other features of the invention are set out in the claims.

### BRIEF DESCRIPTION OF THE DRAWINGS

FIG. 1 is a cross-sectional view showing a semiconductor device according to an embodiment.
FIG. 2 is an enlarged cross-sectional view of area A in FIG. 1.
FIG. 3 is a cross-sectional view showing a semiconductor device according to an embodiment.
FIG. 4 is an enlarged cross-sectional view of area B of FIG. 3.
FIG. 5 is a cross-sectional view showing a semiconductor device according to an embodiment.
FIG. 6 is a cross-sectional view showing a semiconductor device according to an embodiment.
FIG. 7 is a cross-sectional view showing a semiconductor device according to an embodiment.
FIG. 8 is a cross-sectional view showing a semiconductor device according to an embodiment.
FIG. 9 is a cross-sectional view showing a semiconductor device according to an embodiment.
FIG. 10 to FIG. 18 are process cross-sectional views for explaining a manufacturing process of a semiconductor device according to an embodiment.
FIG. 19 to FIG. 27 are process cross-sectional views for explaining a manufacturing process of a semiconductor device according to an embodiment.

### DETAILED DESCRIPTION

Hereinafter, with reference to accompanying drawings, various embodiments of the present disclosure will be described in detail so that a person of an ordinary skill may easily implement the present disclosure. The present disclosure may be implemented in many different forms and is not limited to the embodiments described herein.

In order to clearly explain the present disclosure, parts that are not relevant to the description are omitted, and identical or similar components are assigned the same reference numerals throughout the specification.

In addition, the size and thickness of each component shown in the drawings are shown arbitrarily for convenience of explanation, so the present disclosure is not necessarily limited to what is shown. In the drawings, the thickness of layers, films, panels, portions, etc., are exaggerated for clarity. And in the drawings, for convenience of explanation, the thicknesses of some layers and portions are exaggerated.

It will be understood that when an element such as a layer, film, portion, or substrate is referred to as being "on" another element, it may be directly on the other element or intervening elements may also be present. In contrast, when an element is referred to as being "directly on" another element, there are no intervening elements present. In addition, being "on" or "above" a reference element means being positioned on or below the reference element, and does not necessarily mean being positioned "above" or "on" in a direction opposite to gravity. The terms "upper", "middle", "lower", "top", "bottom", etc. may refer to relative positions along a particular direction (e.g. a vertical direction, such as the second direction D2, described later). Various directions (e.g. vertical direction, horizontal direction, etc.) may be defined relative to the structure of the devices described herein. It will be appreciated that these directions do not necessarily imply any particular orientation of the device in use.

In addition, unless explicitly described to the contrary, the word "comprise", and variations such as "comprises" or "comprising", will be understood to imply the inclusion of stated elements but not the exclusion of any other elements. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

In addition, throughout the specification, when referring to "a plane view", it means that the target portion is viewed from above, and when referring to "a cross-section view", it means that a cross section of the target portion cut vertically is viewed from a side.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

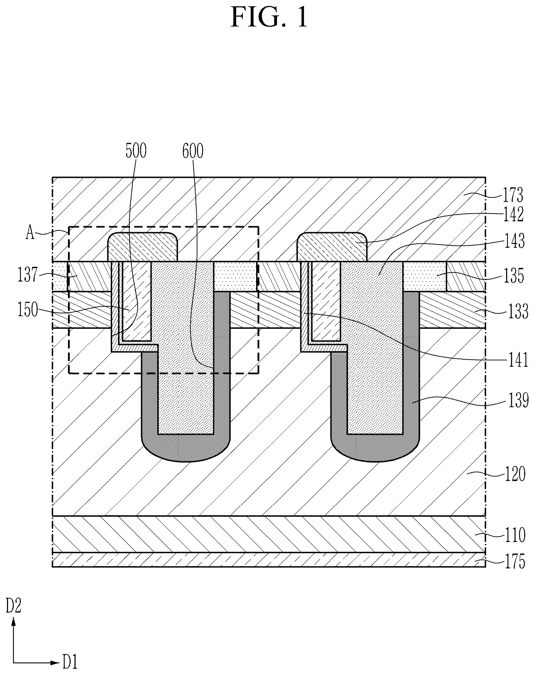

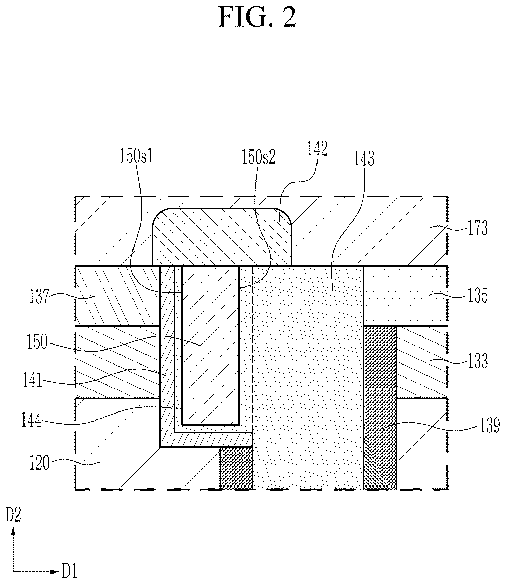

Hereinafter, a semiconductor device according to an embodiment will be described with reference to FIG. 1 and FIG. 2. The semiconductor device may comprise a transistor.

Referring to FIG. 1 and FIG. 2, a semiconductor device according to an embodiment may include a substrate 110, a first conductivity type semiconductor layer 120 on a first surface of the substrate 110, a first trench 500, and a second trench 600 positioned at one side of the first trench 500 and overlapping the first trench 500, a gate electrode 150 in the first trench 500, a first gate insulating layer 141 on the side surface and the lower surface of the gate electrode 150, a second conductivity type doping layer 133 on the first conductivity type semiconductor layer 120, a first conductivity type doped region 137 on the second conductivity type doping layer 133, a source electrode 173 on the first conductivity type doped region 137, a drain electrode 175 on the second surface of the substrate 110, and a shielding pattern 139 around the second trench 600. The first conductivity type semiconductor layer 120 may be otherwise known as a semiconductor layer of a first conductivity type. The second conductivity type doping layer 133 may be otherwise known as a doping layer of a second conductivity type. The first conductivity type doped region 137 may be otherwise known as a doped region of the first conductivity type.

The substrate 110 may be a semiconductor substrate including SiC. For example, the substrate 110 may be made of a 4H SiC substrate. In some cases, the substrate 110 may be made of a 3C SiC substrate, a 6H SiC substrate, etc. The substrate 110 may be doped with n-type dopant. The resistivity of the substrate 110 may be about 0.005 Ωcm or more and about 0.035 Ωcm or less. That is, the resistivity of the substrate 110 may be greater than or equal to 0.005 Ωcm and less then or equal to 0.035 Ωcm. The thickness of the substrate 110 may be about 10 µm or more and about 700 µm or less. That is, the thickness of the substrate 110 may be greater than or equal to 10 µm and less than or equal to 700 µm. The material, doping type, doping concentration, resistivity, thickness, etc. of the substrate 110 are not limited thereto and may be variously modified. The substrate 110 may include a first surface and a second surface opposing each other. The first surface of the substrate 110 may be the upper surface, and the second surface of the substrate 110 may be the lower surface. A first direction D1 may be parallel to the first surface of the substrate 110. The first direction D1 may be a horizontal direction. A second direction D2 may be perpendicular to the first surface of the substrate 110. The second direction D2 may be a vertical direction. Various relative heights (levels) may be defined relative to the second direction D2. For instance, various relative heights (e.g., levels) may refer to respective distances in the second direction D2 from the first surface or second surface of the substrate 110. An upper surface of an element or component may be a surface that is located furthest along the second direction D2. Similarly, a bottom or lower surface of an element or component may be a surface that is located furthest along a direction opposite to the second direction D2.

The first conductivity type semiconductor layer 120 may be positioned on the first surface, i.e., the upper surface, of the substrate 110. The lower surface of the first conductivity type semiconductor layer 120 may be in contact with the upper surface of the substrate 110. However, it is not limited thereto, and another layer may be additionally positioned between the substrate 110 and the first conductivity type semiconductor layer 120. The first conductivity type semiconductor layer 120 may be an epitaxial layer formed from a substrate 110 using an epitaxial growth method. The first conductivity type semiconductor layer 120 may include SiC. For example, the first conductivity type semiconductor layer 120 may include 4H SiC. The first conductivity type semiconductor layer 120 may be doped as n-type. For instance, the first conductivity type may be n-type. The first conductivity type semiconductor layer 120 may be lightly doped as an n-type. The doping concentration of the first conductivity type semiconductor layer 120 may be lower than the doping concentration of the substrate 110. The doping concentration of the first conductivity type semiconductor layer 120 may be about 1.0 × 10¹⁵cm⁻³ or more and about 1.0×10¹⁷cm⁻³ or less. That is, the doping concentration of the first conductivity type semiconductor layer 120 may be greater than or equal to 1.0×10¹⁵cm⁻³ and less than or equal to 1.0×10¹⁷cm⁻³. The thickness of the first conductivity type semiconductor layer 120 may be about 1 µm or more and about 13 µm or less. That is, the thickness of the first conductivity type semiconductor layer 120 may be greater than or equal to 1 µm and less than or equal to 13 µm. The material, doping type, doping concentration, thickness, etc. of the first conductivity type semiconductor layer 120 are not limited thereto and may be variously modified.

The first conductivity type semiconductor layer 120 may include a first trench 500 and a second trench 600 located at one side of the first trench 500. In an embodiment, each unit cell may include one first trench 500 and one second trench 600. The unit cell may be a minimum functional element that performs a specific function in response to a signal received from the outside. In an embodiment, the unit cell may be a switching element. In FIG. 1 and FIG. 2, the unit cell is depicted as having a trench type MOSFET structure, but the structure of the unit cell is not limited thereto. For example, the unit cell may have a planar type MOSFET or a super junction type MOSFET structure. For example, a unit cell may have an IGBT structure.

Referring to FIG. 1 and FIG. 2, within a single unit cell, a second trench 600 may be located at one side of a first trench 500 and may overlap with the first trench 500 in the first direction D1. Within the single unit cell, the first trench 500 and the second trench 600 may be formed integrally. Within the single unit cell, the first trench 500 and the second trench 600 may be positioned continuously in the first direction D1.

The first trench 500 may be formed to have a predetermined depth on (e.g., into or from) the upper surface of the first conductivity type semiconductor layer 120. The depth may be measured in the second direction D2. Referring to FIG. 1 and FIG. 2, in an embodiment, the first trench 500 may include a bottom surface and one side surface extending from the bottom surface. The one side surface of the first trench 500 may be defined by the first conductivity type semiconductor layer 120, the second conductivity type doping layer 133, to be described later, and the first conductivity type doped region 137. The first trench 500 may be defined by the first conductivity type semiconductor layer 120 and the shielding pattern 139, to be described later.

The second trench 600 may be formed to have a predetermined depth on (e.g., into or from) the upper surface of the first conductivity type semiconductor layer 120. The depth may be measured in the second direction D2. In an embodiment, the depth at which the second trench 600 is formed may be deeper than the depth at which the first trench 500 is formed. In an embodiment, the level at which the bottom surface of the second trench 600 is located may be lower than the level at which the bottom surface of the first trench 500 is located. In an embodiment, the bottom surface of the second trench 600 may be positioned closer to the drain electrode 175, to be described later, compared to the bottom surface of the first trench 500.

In an embodiment, the distance between the bottom surface of the second trench 600 and the lower surface of the first conductivity type semiconductor layer 120 may be shorter than the distance between the bottom surface of the second trench 600 and the upper surface of the first conductivity type semiconductor layer 120. The upper surface of the first conductivity type semiconductor layer 120 may be the surface in contact with the second conductivity type doping layer 133.

Unlike what is shown in FIG. 1 and FIG. 2, the depth at which the second trench 600 is formed may be substantially equal to or less than the depth at which the first trench 500 is formed. That is, the application is not limited to the second trench 600 being deeper than the first trench 500, and instead, the depth at which the second trench 600 is formed may be less than or equal to the depth at which the first trench 500 is formed.

Referring to FIG. 1 and FIG. 2, in the embodiment, the second trench 600 may include a bottom surface and two sidewalls extending from opposite ends of the bottom surface. One sidewall of the second trench 600 may include a portion facing the sidewall of the first trench 500 in the opposite direction to the first direction D1. The other sidewall of the second trench 600 may face a portion of the one sidewall of the second trench 600 in the first direction D1. The other sidewall of the second trench 600 may be located between the one sidewall of the first trench 500 and the one sidewall of the second trench 600. The one sidewall of the second trench 600 may include respective portions facing the other sidewall of the second trench 600 and the one sidewall of the first trench 500 in a direction opposite to the first direction D1.

Referring to FIG. 1 and FIG. 2, the length by which the one sidewall of the second trench 600 extends along the second direction D2 may be longer than the length by which the other sidewall of the second trench 600 extends along the second direction D2. In the embodiment, a length by which the one sidewall of the second trench 600 extends in the second direction D2 may be substantially equal to a combined length of a length by which the other sidewall of the second trench 600 extends in the second direction D2 and a length by which the one sidewall of the first trench 500 extends in the second direction D2.

The one sidewall of the second trench 600 may be defined by a second conductivity type doped region 135 and the shielding pattern 139, which will be described later. The bottom surface and other sidewall of the second trench 600 may be defined by a shielding pattern 139. In FIG. 1 and FIG. 2, the angles of the two sidewalls of the second trench 600 with respect to the bottom surface of the second trench 600 are illustrated as being perpendicular, but are not limited thereto. Each of the first trench 500 and the second trench 600 may extend in a direction opposite to the second direction D2 from a level of an upper surface of one or both of the first conductivity type doped region 137 and the second conductivity type doped region 135 into the first conductivity type semiconductor layer 120. The second conductivity type doped region 137 may be otherwise known as a doped region of the second conductivity type.

The gate electrode 150 may be positioned within the first trench 500 of the first conductivity type semiconductor layer 120. The gate electrode 150 may be spaced apart from the first conductivity type semiconductor layer 120. The distance at which the gate electrode 150 is separated from the first conductivity type semiconductor layer 120 may be substantially constant. However, it is not limited thereto, and the distance between the gate electrode 150 and the first conductivity type semiconductor layer 120 may not be uniform (e.g., may vary) depending on the position. The gate electrode 150 may have a cross-sectional shape similar to (e.g., the same as) that of the first trench 500. In the cross-sectional views of FIG. 1 and FIG. 2, the gate electrode 150 is depicted as having an approximately rectangular shape, but is not limited thereto. For example, the gate electrode 150 may have a trapezoidal shape in which the width in the first direction D1 gradually narrows from top to bottom, and may have various other shapes as well.

The gate electrode 150 may include a lower surface and side surfaces 150s1, 150s2 extending from the lower surface. The lower surface and the side surfaces 150s1, 150s2 of the gate electrode 150 may form a U-shaped profiled (e.g., an approximately U-shaped profile) in cross section. The side surfaces 150s1, 150s2 of the gate electrode 150 may extend in a direction parallel to each other. The side surfaces 150s1, 150s2 of the gate electrode 150 may extend in the second direction D2, but are not limited thereto.

The gate electrode 150 may further include an upper surface facing the lower surface, and the side surfaces 150s1, 150s2 may connect the lower surface and the upper surface.

The lower surface of the gate electrode 150 may face the bottom surface of the first trench 500. A first side surface 150s1 of the gate electrode 150 may face the one sidewall of the first trench 500. The first side surface 150s1 of the gate electrode 150 may include a portion that overlaps the first conductivity type doped region 137 and the second conductivity type doping layer 133 in the first direction D1, which will be described later. The second side surface 150s2 of the gate electrode 150 may face the one sidewall of the second trench 600. The upper surface of the gate electrode 150 may be in contact with the lower surface of a capping layer 142 to be described later. The upper surface of the gate electrode 150 may be positioned at substantially the same level as the upper surface of the first conductivity type doped region 137 and the upper surface of the second conductivity type doped region 135, which will be described later.

In an embodiment, the width of the gate electrode 150 along the horizontal direction (e.g., the first direction D1) may be narrower than the width of the first trench 500 along the horizontal direction (e.g., the first direction D1).

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal nitride, or a combination thereof. The gate electrode 150 may be formed of a single layer or multiple layers.

The semiconductor device according to the embodiment may further include an internal insulating pattern 143 filling the interior of the second trench 600. In an embodiment, the internal insulating pattern 143 may completely fill the interior of the second trench 600. The internal insulating pattern 143 may cover the bottom surface and two sidewalls of the second trench 600. The upper surface of the internal insulating pattern 143 may be positioned at substantially the same level as the upper surface of the gate electrode 150. The internal insulating pattern 143 may be surrounded by at least a portion of the shielding pattern 139. Referring to FIG. 1 and FIG. 2, at least a portion of the side surface and the lower surface of the internal insulating pattern 143 may be surrounded by a shielding pattern 139. The lower surface of the internal insulating pattern 143 may be covered by a shielding pattern 139. One side surface of the internal insulating pattern 143 may be covered by the second conductivity type doped region 135 and the shielding pattern 139. The other side surface of the internal insulating pattern 143 may be covered by the shielding pattern 139, a first gate insulating layer 141 and a second gate insulating layer 144 to be described later.

In an embodiment, the lower surface of the internal insulating pattern 143 may be positioned adjacent to the drain electrode 175 or the substrate 110. In an embodiment, the distance between the level at which the lower surface of the internal insulating pattern 143 is located and the level at which the lower surface of the first conductivity type semiconductor layer 120 is located may be shorter than the distance between the level at which the lower surface of the internal insulating pattern 143 is located and the level at which the upper surface of the first conductivity type semiconductor layer 120 is located.

The internal insulating pattern 143 may include an insulating material. For example, the internal insulating pattern 143 may include silicon oxide (SiO₂). However, it is not limited thereto, and the internal insulating pattern 143 may include various insulating materials. For example, the internal insulating pattern 143 may include silicon nitride (SiN), silicon oxynitride (SiON), silicon carbon nitride (SiCN), or a combination thereof. The internal insulating pattern 143 may be formed of a single layer or multiple layers.

The first gate insulating layer 141 may surround at least a portion of the gate electrode 150. The first gate insulating layer 141 may be positioned over at least a portion of the gate electrode 150. In an embodiment, the first gate insulating layer 141 may be positioned on the bottom surface of the gate electrode 150 and on the first side surface 150s1 of the gate electrode 150. In an embodiment, the first gate insulating layer 141 may not be positioned on the second side surface 150s2 of the gate electrode 150.

The first gate insulating layer 141 may be positioned between the gate electrode 150 and the first conductivity type semiconductor layer 120. The first gate insulating layer 141 may be positioned between the gate electrode 150 and the second conductivity type doping layer 133 to be described later, and between the gate electrode 150 and the first conductivity type doped region 137.

The first gate insulating layer 141 may be positioned on the bottom surface and the one sidewall of the first trench 500. The first gate insulating layer 141 may be positioned with a substantially uniform thickness on the bottom surface and on the one sidewall of the first trench 500.

The first gate insulating layer 141 may include an insulating material. In an embodiment, the first gate insulating layer 141 may include a thermal oxidation layer formed by a thermal oxidation process. For example, the first gate insulating layer 141 may include silicon oxide (SiO₂) formed by a thermal oxidation process. However, it is not limited thereto, and the material of the first gate insulating layer 141 may be variously modified. As another example, the first gate insulating layer 141 may include silicon nitride (SiN), silicon oxynitride (SiON), silicon carbide (SiC), silicon carbonitride (SiCN), or a combination thereof. The first gate insulating layer 141 may be formed of a single layer or multiple layers.

The semiconductor device according to the embodiment may further include a second gate insulating layer 144 positioned between the gate electrode 150 and the first gate insulating layer 141. The second gate insulating layer 144 may cover the both side surfaces 150s1, 150s2 and the lower surface of the gate electrode 150. The second gate insulating layer 144 may be positioned between the first side surface 150s1 of the gate electrode 150 and the first gate insulating layer 141. The second gate insulating layer 144 may also be located between the lower surface of the gate electrode 150 and the first gate insulating layer 141.

Referring to FIG. 2, the second gate insulating layer 144 may also be positioned between the second side surface 150s2 of the gate electrode 150 and the internal insulating pattern 143. In an embodiment, the second gate insulating layer 144 may include an insulating material. The second gate insulating layer 144 may include silicon oxide (SiO₂). However, it is not limited thereto, and the internal insulating pattern 143 may include various insulating materials. For example, the internal insulating pattern 143 may include silicon nitride (SiN), silicon oxynitride (SiON), silicon carbon nitride (SiCN), or a combination thereof. The internal insulating pattern 143 may be formed of a single layer or multiple layers.

In the embodiment, the second gate insulating layer 144 may include the same insulating material as the insulating material included in the internal insulating pattern 143. Referring to FIG. 2, a boundary between the second gate insulating layer 144 and the internal insulating pattern 143 is illustrated as being present, but the boundary between them may not be visually distinguishable if the second gate insulating layer 144 and the internal insulating pattern 143 include the same insulating material. In FIG. 2, the second gate insulating layer 144 and the internal insulating pattern 143 are depicted as separate structures, but the internal insulating pattern 143 and the second gate insulating layer 144 may be integrally formed. In an embodiment, the internal insulating pattern 143 and the second gate insulating layer 144 may be formed simultaneously in the same process.

The second conductivity type doping layer 133 may be positioned on the first conductivity type semiconductor layer 120. The second conductivity type doping layer 133 may be a region in which a channel is formed during an ON operation of the semiconductor device according to the embodiment. The second conductivity type doping layer 133 may be a channel region. During an ON operation of the semiconductor device according to an embodiment, when a turn-on voltage is applied to the gate electrode 150, the channel may be formed in the second conductivity type doping layer 133. In this case, current may flow from the drain electrode 175, across the first conductivity type semiconductor layer 120, the second conductivity type doping layer 133, the first conductivity type doped region 137, and the second conductivity type doped region 135, to the source electrode 173. Accordingly, the semiconductor device may comprise a transistor, such as a metal-oxide-semiconductor field effect transistor (MOSFET). For instance, the semiconductor device may comprise a power MOSFET.

The second conductivity type doping layer 133 may overlap in the first direction D1 at least a portion of the gate electrode 150, at least a portion of the first gate insulating layer 141, and at least a portion of the second gate insulating layer 144. The second conductivity type doping layer 133 may face the gate electrode 150 with the first gate insulating layer 141 and the second gate insulating layer 144 interposed therebetween. The surface of the second conductivity type doping layer 133 facing the gate electrode 150 may be positioned on the same boundary line as the one sidewall of the first trench 500. The second conductivity type doping layer 133 may cover at least a portion of the side surface of the first gate insulating layer 141 and the internal insulating pattern 143. A shielding pattern 139, which will be described later, may be positioned between the second conductivity type doping layer 133 and the internal insulating pattern 143.

The second conductivity type doping layer 133 may be an epitaxial layer grown from the first conductivity type semiconductor layer 120 using an epitaxial growth method. Alternatively, the second conductivity type doping layer 133 may be a doped region formed using an ion implantation process (IIP) in the first conductivity type semiconductor layer 120.

The second conductivity type doping layer 133 may include SiC. For example, the second conductivity type doping layer 133 may include 4H SiC. The second conductivity type doping layer 133 may be doped with p type dopants. That is, the second conductivity type may be p type. The second conductivity type doping layer 133 may be lightly doped with p type dopants. The doping concentration of the second conductivity type doping layer 133 may be about 1.0×10¹⁷cm⁻³ or more and about 1.0×10¹⁹cm⁻³ or less. That is, the doping concentration of the second conductivity type doping layer 133 may be greater than or equal to 1.0×10¹⁷cm⁻³ and less than or equal to 1.0×10¹⁹cm⁻³. The material, doping type, doping concentration, and thickness of the second conductivity type doping layer 133 are not limited thereto and may be variously modified.

The first conductivity type doped region 137 may be positioned on the second conductivity type doping layer 133. The first conductivity type doped region 137 may be located between the second conductivity type doping layer 133 and the source electrode 173, to be described later.

The first conductivity type doped region 137 may cover at least a portion of the first gate insulating layer 141. The first conductivity type doped region 137 may face the gate electrode 150 with the first gate insulating layer 141 and the second gate insulating layer 144 interposed therebetween. The surface of the first conductivity type doped region 137 facing the gate electrode 150 may be located on the same boundary line as the sidewall of the first trench 500. The upper surface of the first conductivity type doped region 137 may be in contact with the source electrode 173 to be described later. The lower surface of the first conductivity type doped region 137 may be in contact with the second conductivity type doping layer 133. At least a portion of the upper surface of the first conductivity type doped region 137 may be covered by a capping layer 142, but is not limited thereto.

The first conductivity type doped region 137 may be a region formed in the first conductivity type semiconductor layer 120 using an ion implantation process. The first conductivity type doped region 137 may include SiC. For example, the first conductivity type doped region 137 may include 4H SiC. The first conductivity type doped region 137 may be doped with n type dopants. The first conductivity type doped region 137 may be highly doped with n type dopants. The doping concentration of the first conductivity type doped region 137 may be about 1.0×10¹⁸cm⁻³ or more and about 5.0×10²⁰cm⁻³ or less. That is, the doping concentration of the first conductivity type doped region 137 may greater than or equal to 1.0× 10¹⁸cm⁻³ and less than or equal to 5.0×10²⁰cm⁻³. The material, doping type, and doping concentration of the first conductivity type doped region 137 are not limited thereto and may be variously modified.

The semiconductor device according to the embodiment may further include a second conductivity type doped region 135 positioned on the second conductivity type doping layer 133. In an embodiment, the second conductivity type doped region 135 may be positioned at one side of the first conductivity type doped region 137. The second conductivity type doped region 135 may be positioned at substantially the same level (e.g., in the second direction D2) as the first conductivity type doped region 137. The upper surface of the second conductivity type doped region 135 may be positioned at substantially the same level (e.g., in the second direction D2) as the upper surface of the first conductivity type doped region 137. The second conductivity type doped region 135 may have one side surface in contact with the first conductivity type doped region 137. The second conductivity type doped region 135 may have the other side surface in contact with the internal insulating pattern 143.

The second conductivity type doped region 135 may be positioned between the second conductivity type doping layer 133 and the source electrode 173. The lower surface of the second conductivity type doped region 135 may be in contact with the second conductivity type doping layer 133. At least a portion of the lower surface of the second conductivity type doped region 135 may be in contact with the shielding pattern 139, to be described later. The upper surface of the second conductivity type doped region 135 may be in contact with the source electrode 173. The second conductivity type doped region 135 may form an ohmic contact with the source electrode 173.

The second conductivity type doped region 135 may be a region formed in the first conductivity type semiconductor layer 120 using an ion implantation process. The second conductivity type doped region 135 may include SiC. For example, the second conductivity type doped region 135 may include 4H SiC. The second conductivity type doped region 135 may be doped with p type dopants. The second conductivity type doped region 135 may be heavily doped with p type dopants. The doping concentration of the second conductivity type doped region 135 may be about 1.0×10¹⁸cm⁻³ or more and about 5.0×10²⁰cm⁻³ or less. That is, the doping concentration of the second conductivity type doped region 135 may be greater than or equal to 1.0×10¹⁸cm⁻³ and less than or equal to 5.0×10²⁰cm⁻³. The material, doping type, and doping concentration of the second conductivity type doped region 135 are not limited thereto and may be variously modified.

The semiconductor device according to the embodiment may further include a capping layer 142 positioned over the gate electrode 150. The capping layer 142 may cover the upper surface of the gate electrode 150. Additionally, the capping layer 142 may cover at least a portion of the first gate insulating layer 141, the second gate insulating layer 144 and the first conductivity type doped region 137 adjacent to the gate electrode 150. The capping layer 142 may be surrounded by a source electrode 173, which will be described later. The gate electrode 150 may be insulated from the source electrode 173 by the capping layer 142.

The capping layer 142 may include an insulating material. For example, the capping layer 142 may include silicon oxide (SiO₂), silicon oxyphosphide (SiOP), silicon nitride (SiN), silicon oxynitride (SiON), or a combination thereof. However, it is not limited thereto, and the material of the capping layer 142 may be variously modified. The capping layer 142 may be formed of a single layer or multiple layers. The capping layer 142 may include the same material as the first gate insulating layer 141 or may include a different material. When the capping layer 142 is formed of the same material as the first gate insulating layer 141, a boundary between the capping layer 142 and the first gate insulating layer 141 may not be clearly distinguishable at an interface where they contact each other.

The source electrode 173 may be positioned on the first conductivity type semiconductor layer 120. The source electrode 173 may be positioned on the upper surface of the first conductivity type doped region 137 and the upper surface of the second conductivity type doped region 135.

The source electrode 173 may include a conductive material. For example, the source electrode 173 may include a metal, a metal alloy, a conductive metal nitride, a metal silicide, a doped semiconductor material, a conductive metal oxide, or a conductive metal oxynitride. For example, the source electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but is not limited thereto. The source electrode 173 may be formed of a single layer or multiple layers.

The drain electrode 175 may be positioned on the second surface, that is, the lower surface, of the substrate 110. The upper surface of the drain electrode 175 may be in contact with the lower surface of the substrate 110. The drain electrode 175 may be in ohmic contact with the substrate 110. In the substrate 110, a region in contact with the drain electrode 175 may be doped at a relatively high (e.g., higher) concentration compared to other regions. However, it is not limited thereto, and another layer may be additionally positioned between the drain electrode 175 and the substrate 110.

The drain electrode 175 may include a conductive material. For example, the drain electrode 175 may include a metal, a metal alloy, a conductive metal nitride, a metal silicide, a doped semiconductor material, a conductive metal oxide, or a conductive metal nitride. The drain electrode 175 may be made of the same material as the source electrode 173 or may be made of a different material. The drain electrode 175 may be formed of a single layer or multiple layers.

The shielding pattern 139 may be positioned around the second trench 600. The shielding pattern 139 in the semiconductor device according to the embodiment may be intended to alleviate the electric field which may be concentrated around the first gate insulating layer 141 or the second gate insulating layer 144, and to increase a breakdown voltage.

The shielding pattern 139 may surround at least a portion of the second trench 600. The shielding pattern 139 may surround the bottom surface of the second trench 600 and at least a portion of the two sidewalls of the second trench 600. The shielding pattern 139 may surround at least a portion of the side surface and the lower surface of the internal insulating pattern 143 that fills the interior of the second trench 600. The shielding pattern 139 may be positioned between the lower surface of the internal insulating pattern 143 and the first conductivity type semiconductor layer 120. The shielding pattern 139 may also be positioned between the side surface of the internal insulating pattern 143 and the first conductivity type semiconductor layer 120. At a level higher than the upper surface of the first conductivity type semiconductor layer 120, the shielding pattern 139 may also be positioned between the internal insulating pattern 143 and the second conductivity type doping layer 133.

The shielding pattern 139 may be formed with a predetermined width. Referring to FIG. 1 and FIG. 2, the width of the shielding pattern 139, which is located on a lower surface of the internal insulating pattern 143, in a second direction D2, may gradually decrease toward both ends of the lower surface of the internal insulating pattern 143, but is not limited thereto. The shielding pattern 139, which is positioned on a side surface of the internal insulating pattern 143, may have a uniform width in a first direction D1, but is not limited thereto.

In the embodiment, a length in the second direction D2 of a portion of the shielding pattern 139 positioned on the one side surface of the internal insulating pattern 143 adjacent to the gate electrode 150 may be shorter than a length in the second direction D2 of a portion of the shielding pattern 139 positioned on the other side surface of the internal insulating pattern 143.

In an embodiment, an upper surface of a portion of the shielding pattern 139, which is positioned on the one side surface of the internal insulating pattern 143 adjacent to the gate electrode 150, may cover at least a portion of a lower surface of the first gate insulating layer 141. Referring to FIG. 1, the shielding pattern 139 is illustrated as covering only a portion of the lower surface of the first gate insulating layer 141, but alternatively, the shielding pattern 139 may cover the entire lower surface of the first gate insulating layer 141.

In the embodiment, an upper surface of a portion of the shielding pattern 139, which is positioned on the other side surface of the internal insulating pattern 143 facing the one side surface of the internal insulating pattern 143 adjacent to the gate electrode 150, may cover at least a portion of a lower surface of the second conductivity type doped region 135.

The shielding pattern 139 may be a region formed in the first conductivity type semiconductor layer 120 using an ion implantation process. Specifically, the shielding pattern 139 may be a doped region formed by forming a second trench 600 in the first conductivity type semiconductor layer 120 and then injecting ions into the bottom surface and both sidewalls of the second trench 600 through an ion implantation process. The shielding pattern 139 may include SiC. For example, the shielding pattern 139 may include 4H SiC.

In the embodiment, the shielding pattern 139 may have a different conductivity type (e.g., the second conductivity type) from that of the first conductivity type semiconductor layer 120. For example, the shielding pattern 139 may be doped with p-type dopants. In an embodiment, the shielding pattern 139 may be doped at a relatively high concentration compared to the first conductivity type semiconductor layer 120. That is, the shielding pattern 139 may have a higher doping concentration than the first conductivity type semiconductor layer 120. Although not clearly illustrated in FIG. 1 and FIG. 2, in this case, a depletion region formed around a boundary between the first conductivity type semiconductor layer 120 and the shielding pattern 139 may extend widely and deeply toward the first conductivity type semiconductor layer 120.

In an embodiment, the depletion region which is positioned around the boundary between the portion of the shielding pattern 139 on the lower surface of the internal insulating pattern 143 and the first conductivity type semiconductor layer 120 may be formed to extend to an upper surface of the substrate 110 or a region adjacent to the upper surface of the substrate 110.

In an embodiment, a depletion region, which is positioned around a boundary between the portion of the shielding pattern 139 on the one side surface of the internal insulating pattern 143 adjacent to the gate electrode 150 and the first conductivity type semiconductor layer 120, may be formed to overlap the entire lower surface of the first gate insulating layer 141 in a second direction D2.

According to an embodiment, as the shielding pattern 139 is positioned on the lower surface of the first gate insulating layer 141, an electric field concentrated around the first gate insulating layer 141 may be alleviated, thereby improving the reliability of the semiconductor device.

A semiconductor device according to the embodiment may include the second trench 600 formed deeper than the first trench 500 and positioned to overlap the first trench 500 in a horizontal direction (for example, the first direction D1 in FIG. 1) at one side of the first trench 500, and the shielding pattern 139 may be positioned around the second trench 600. According to the embodiment, the depletion region formed around the interface between the shielding pattern 139 and the first conductivity type semiconductor layer 120 may increase the breakdown voltage of the semiconductor device, thereby improving the reliability of the semiconductor device

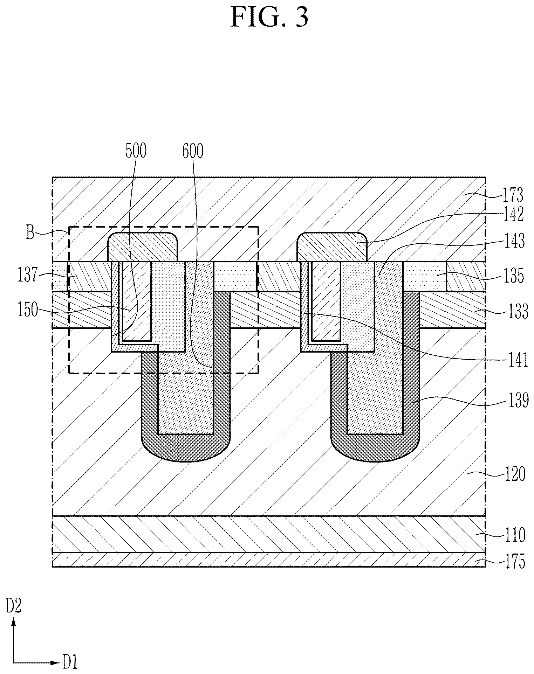

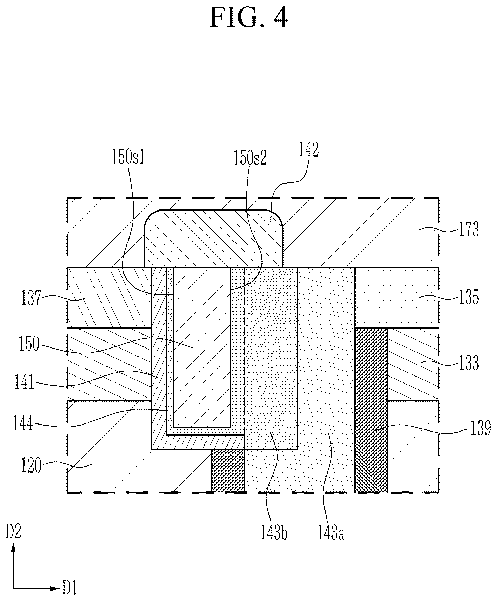

FIG. 3 and FIG. 4 are drawings for explaining a semiconductor device according to an embodiment. Specifically, FIG. 3 is a cross-sectional view showing a semiconductor device according to an embodiment, and FIG. 4 is an enlarged cross-sectional view of area B of FIG. 3. The semiconductor devices illustrated in FIG. 3 and FIG. 4 have many similarities compared to the previous embodiments, so the following description focuses mainly on the differences from the previous embodiments.

In a semiconductor device according to an embodiment, the internal insulating pattern 143 may include a first internal insulating pattern 143a and a second internal insulating pattern 143b.

In an embodiment, the first internal insulating pattern 143a and the second internal insulating pattern 143b may be formed in different processes. For example, the second internal insulating pattern 143b may be formed by first filling the entire interior of the second trench 600 with the first internal insulating pattern 143a, etching a portion of the first internal insulating pattern 143a, and then filling the etched portion with an insulating material

The second internal insulating pattern 143b may be positioned between the gate electrode 150 and the first internal insulating pattern 143a. In an embodiment, the lower surface of the second internal insulating pattern 143b may be positioned at substantially the same level as the lower surface of the first gate insulating layer 141. A portion of the upper surface of the second internal insulating pattern 143b may be covered by a capping layer 142. The one side surface and the lower surface of the second internal insulating pattern 143b may be covered by the first internal insulating pattern 143a.

The second internal insulating pattern 143b may include an insulating material. The second internal insulating pattern 143b may include silicon oxide (SiO₂). However, it is not limited thereto, and the second internal insulating pattern 143b may include various insulating materials. For example, the second internal insulating pattern 143b may include silicon nitride (SiN), silicon oxynitride (SiON), silicon carbon nitride (SiCN), or a combination thereof. The second internal insulating pattern 143b may be formed of a single layer or multiple layers. In an embodiment, the second internal insulating pattern 143b may include the same insulating material as the first internal insulating pattern 143a. In this case, the boundary between the first internal insulating pattern 143a and the second internal insulating pattern 143b may not be recognized.

In the embodiment, the second gate insulating layer 144 may include the same insulating material as the insulating material included in the second internal insulating pattern 143b. Referring to FIG. 4, although a boundary appears to exist between the second gate insulating layer 144 and the second internal insulating pattern 143b, when the second gate insulating layer 144 and the second internal insulating pattern 143b include the same insulating material, the boundary between the second gate insulating layer 144 and the second internal insulating pattern 143b may not be visually distinguishable. In FIG. 4, the second gate insulating layer 144 and the second internal insulating pattern 143b are illustrated as separate components, but the second internal insulating pattern 143b and the second gate insulating layer 144 may be integrally formed. In an embodiment, the second internal insulating pattern 143b and the second gate insulating layer 144 may be formed simultaneously in the same process.

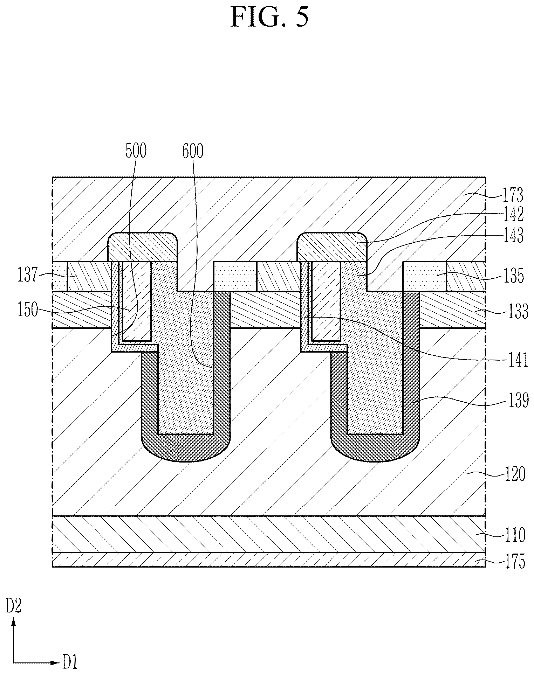

FIG. 5 is a cross-sectional view showing a semiconductor device according to an embodiment. The semiconductor device illustrated in FIG. 5 has many similarities compared to the previous embodiments, so the following description focuses mainly on the differences from the previous embodiments. Specifically, the semiconductor device illustrated in FIG. 5 may have a structure of the source electrode 173 that is somewhat different from that of the previous embodiments.

Referring to FIG. 5, in a semiconductor device according to an embodiment, in a portion where the source electrode 173 and the internal insulating pattern 143 overlap in the second direction D2, the source electrode 173 may extend into the internal insulating pattern 143 by a predetermined depth. In FIG. 5, the lower surface of the region of the source electrode 173 extending into the internal insulating pattern 143 may be positioned at substantially the same level as the lower surface of the second conductivity type doped region 135, but is not limited thereto. For example, the source electrode 173 may extend to a level lower than the lower surface of the second conductivity type doped region 135.

In an embodiment, one side of the second conductivity type doped region 135 may be in contact with the source electrode 173. Unlike the previous examples, the second conductivity type doped region 135 may be in contact with the source electrode 173 at the upper and lower surfaces.

According to an embodiment, the area in which the second conductivity type doped region 135 is in contact with the source electrode 173 may increase, and the contact resistance between the second conductivity type doped region 135 and the source electrode 173 may be reduced, so that the electrical characteristics of the semiconductor device according to the embodiment may be improved.

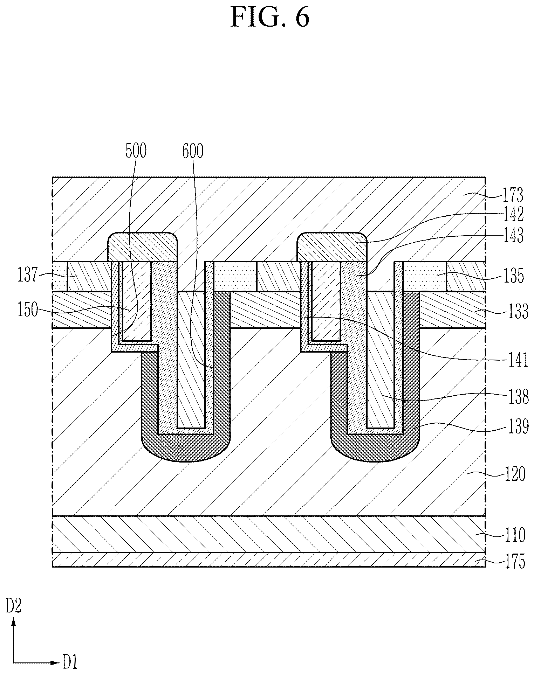

FIG. 6 is a cross-sectional view showing a semiconductor device according to an embodiment. The semiconductor device illustrated in FIG. 6 has many similarities compared to the previous embodiments, so the following description focuses on the differences from the previous embodiments. Specifically, the semiconductor device illustrated in FIG. 6 may differ in part from the foregoing embodiments in that it further includes a dummy semiconductor pattern 138.

Referring to FIG. 6, the dummy semiconductor pattern 138 may be positioned inside the second trench 600. A dummy semiconductor pattern 138 may be formed by etching a portion of an internal insulating pattern 143 that fills the inside of a second trench 600 and then filling the etched portion with a semiconductor material.

The dummy semiconductor pattern 138 may extend in the second direction D2. Referring to FIG. 6, the upper surface of the dummy semiconductor pattern 138 may be positioned at substantially the same level as the upper surface of the second conductivity type doping layer 133. Unlike what is illustrated in FIG. 6, the upper surface of the dummy semiconductor pattern 138 may be positioned at the same level as the upper surface of the gate electrode 150, the internal insulating pattern 143, the first conductivity type doped region 137 and/or the second conductivity type doped region 135.

The lower surface of the dummy semiconductor pattern 138 may be positioned at a higher level than the lower surface of the internal insulating pattern 143. However, it is not limited to thereto, and the lower surface of the dummy semiconductor pattern 138 may be positioned at the same level as the lower surface of the internal insulating pattern 143.

The dummy semiconductor pattern 138 may include a semiconductor material. For example, the dummy semiconductor pattern 138 may include the same material as the gate electrode 150. For example, the dummy semiconductor pattern 138 may include polysilicon. In an embodiment, the dummy semiconductor pattern 138 may be an undoped intrinsic semiconductor, but is not limited to.

Polysilicon may have high rigidity compared to silicon oxide (SiO₂). Additionally, polysilicon may fill the inside of trenches well without forming voids compared to silicon oxide (SiO₂). According to an embodiment, the interior of the second trench 600 may be filled with a dummy semiconductor pattern 138 including polysilicon, and thus, the reliability of the semiconductor device may be improved.

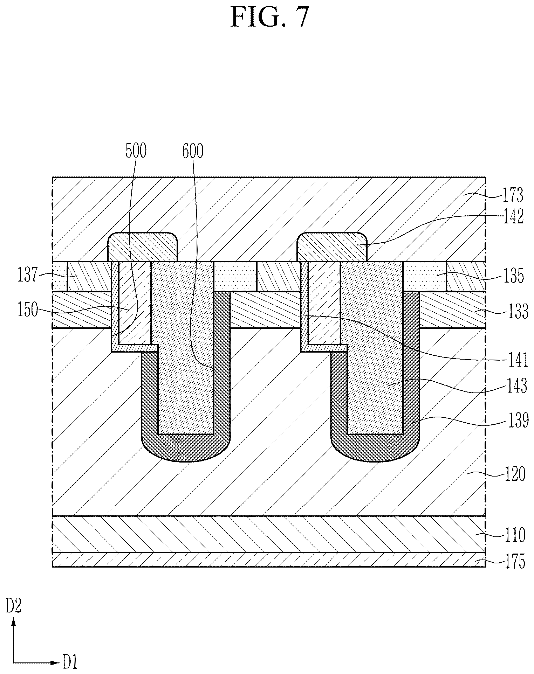

FIG. 7 is a cross-sectional view showing a semiconductor device according to an embodiment. The semiconductor device illustrated in FIG. 7 has many similarities compared to the previous embodiments, so the following description focuses on the differences from the previous embodiments. Specifically, the semiconductor device illustrated in FIG. 7 may be partially different from the foregoing embodiments in terms of the structure and position of the gate electrode 150.

Referring to FIG. 7, in a semiconductor device according to an embodiment, a second gate insulating layer 144 may not be positioned between the first gate insulating layer 141 and the gate electrode 150. Specifically, in the semiconductor device described with reference to FIG. 1 and FIG. 2, the second gate insulating layer 144 is positioned between the first side surface 150s1 of the gate electrode 150 and the first gate insulating layer 141, and between the lower surface of the gate electrode 150 and the first gate insulating layer 141. In contrast, in the semiconductor device according to the embodiment of FIG. 7, the second gate insulating layer 144 may not be positioned between the first side surface 150s1 of the gate electrode 150 and the first gate insulating layer 141, and between the lower surface of the gate electrode 150 and the first gate insulating layer 141.

In an embodiment, one side and the lower surface of the gate electrode 150 may be in contact with the first gate insulating layer 141.

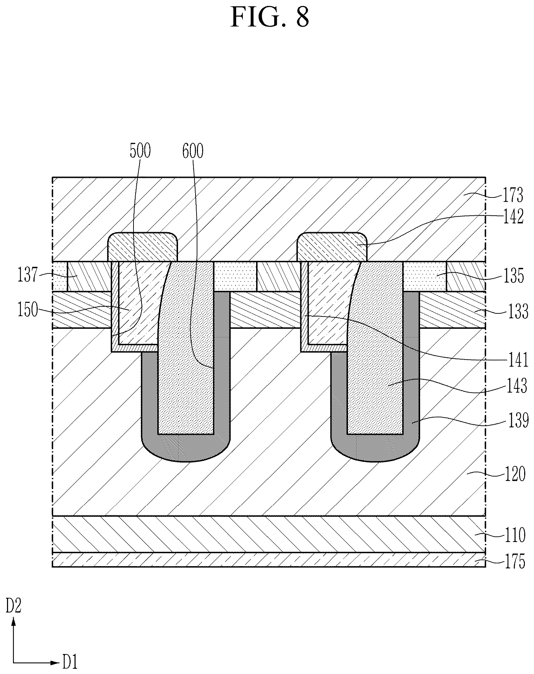

FIG. 8 is a cross-sectional view showing a semiconductor device according to an embodiment. The semiconductor device illustrated in FIG. 8 has many similarities compared to the previous embodiments, so the following description focuses on the differences from the previous embodiments. Specifically, the shape of the gate electrode 150 in the semiconductor device illustrated in FIG. 8 may be partially different from that of the foregoing embodiments.

In an embodiment, the gate electrode 150 may have a width in the first direction D1 that gradually decreases from top to bottom (e.g., that gradually decreases as the gate electrode 150 extends towards the drain electrode 175). Referring to FIG. 8, in the embodiment, among the two side surfaces of the gate electrode 150, the side surface in contact with the first gate insulating layer 141 may extend parallel to the second direction D2. In the embodiment, among the two side surfaces of the gate electrode 150, the side surface in contact with the internal insulating pattern 143 may extend in an inclined direction (e.g., may be inclined or sloped) with respect to a second direction D2. In the embodiment, among the two side surfaces of the gate electrode 150, the side surface in contact with the internal insulating pattern 143 may extend in a diagonal direction between the first direction D1 and the second direction D2. The slope of the inclined side surface may vary in the second direction D2. For instance, the slope may increase from top to bottom.

In a region where the internal insulating pattern 143 overlaps with the gate electrode 150 in a first direction D1, the internal insulating pattern 143 may have a width in the first direction D1 that gradually increases from top to bottom. Referring to FIG. 8, in the embodiment, among the two side surfaces of the internal insulating pattern 143, the side surface in contact with the shielding pattern 139 and the second conductivity type doped region 135 may extend in the second direction D2. In an embodiment, one of the two side surfaces of the internal insulating pattern 143 that is in contact with the gate electrode 150 may include an inclined region. In an embodiment, in a region where the internal insulating pattern 143 overlaps the gate electrode 150 in the first direction D1, the side surface of the internal insulating pattern 143 that is in contact with the gate electrode 150 may extend in a diagonal direction between the first direction D1 and the second direction D2. The slope of the inclined side surface may vary in the second direction D2. For instance, the slope may increase from top to bottom

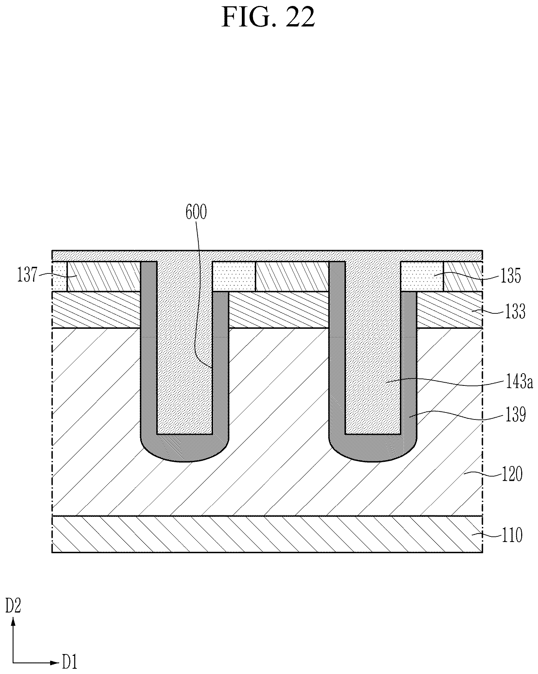

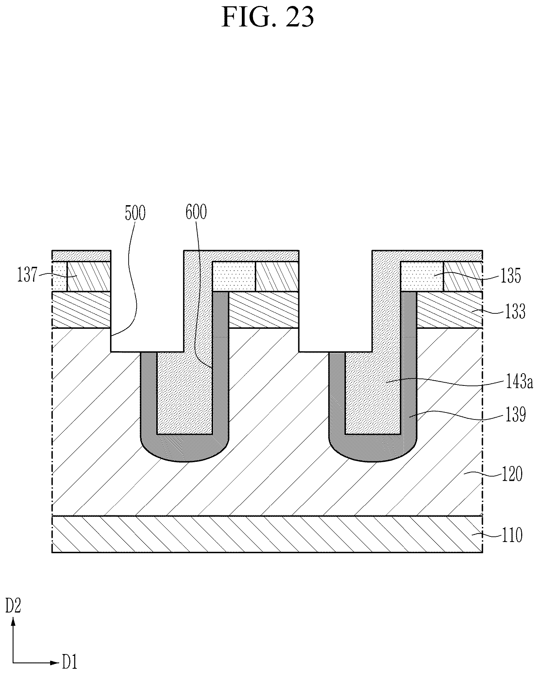

The shapes of the gate electrode 150 and the internal insulating pattern 143, described with reference to FIG. 8, may result from a difference in etch selectivity between silicon carbide (SiC), which is included in the first conductivity type doped region 137, the second conductivity type doping layer 133, the first conductivity type semiconductor layer 120, and the shielding pattern 139, and silicon oxide (SiO₂), which is included in the internal insulating pattern 143, during the process of forming the first trench 500 (see FIG. 22 and FIG. 23).

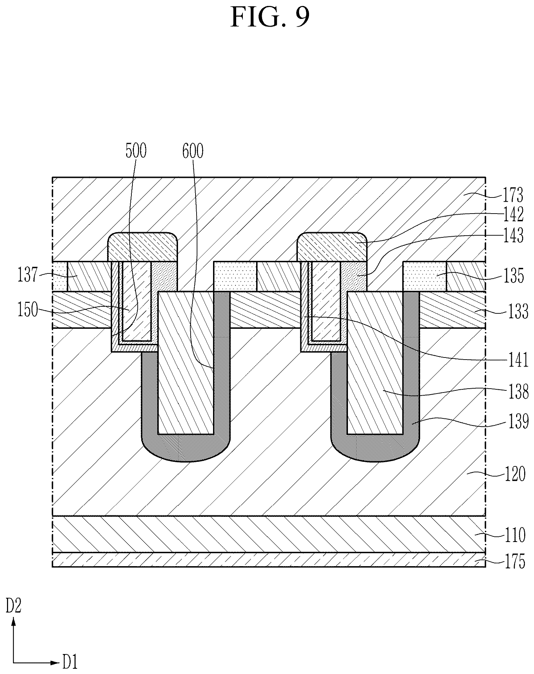

FIG. 9 is a cross-sectional view showing a semiconductor device according to an embodiment. The semiconductor device illustrated in FIG. 9 has many similarities compared to the previous embodiments, so the following description focuses on the differences from the previous embodiments.

Referring to FIG. 9, a dummy semiconductor pattern 138 may be positioned inside the second trench 600. In the embodiment, the entire inner area of the second trench 600 positioned at the level lower than the upper surface of the second conductivity type doping layer 133 may be filled by the dummy semiconductor pattern 138. The dummy semiconductor pattern 138 may cover the bottom surface and both sidewalls of the second trench 600. The upper surface of the dummy semiconductor pattern 138 may be positioned at substantially the same level as the upper surface of the second conductivity type doping layer 133. At least portions of the lower surface and both side surfaces of the dummy semiconductor pattern 138 may be surrounded by the shielding pattern 139. In an embodiment, a portion of the upper surface of the dummy semiconductor pattern 138 may be in contact with the source electrode 173. Referring to FIG. 9, an internal insulating pattern 143 may be positioned between the capping layer 142 and the dummy semiconductor pattern 138 at a level higher than the upper surface of the second conductivity type doping layer 133.

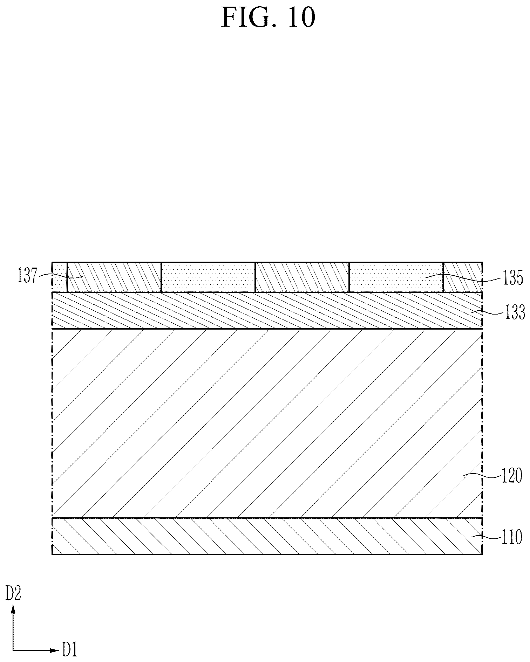

FIG. 10 to FIG. 18 are process cross-sectional views for explaining a manufacturing process of a semiconductor device according to an embodiment. Specifically, FIG. 10 to FIG. 18 are process cross-sectional views for explaining the manufacturing process of the semiconductor device described with reference to FIG. 1 and FIG. 2.

As illustrated in FIG. 10, a second conductivity type doping layer 133, a first conductivity type doped region 137, and a second conductivity type doped region 135 may be sequentially formed on top of a first conductivity type semiconductor layer 120 positioned on a substrate 110.

The substrate 110 may be a semiconductor substrate including SiC. For example, the substrate 110 may be made of a 4H SiC substrate. The substrate 110 may be doped with n-type dopants. For instance, the substrate 110 may be highly doped with n-type dopants. The substrate 110 may include a first side and a second side facing away from each other (e.g., opposite to each other). The first surface of the substrate 110 may be the upper surface, and the second surface of the substrate 110 may be the lower surface.

A first conductivity type semiconductor layer 120 may be formed on the first surface, i.e., the upper surface, of the substrate 110 using an epitaxial growth method. The first conductivity type semiconductor layer 120 may be formed directly on the substrate 110, or a predetermined other layer may be formed on the substrate 110, and then the first conductivity type semiconductor layer 120 may be formed on that. The first conductivity type semiconductor layer 120 may include SiC. For example, the first conductivity type semiconductor layer 120 may include 4H SiC. The first conductivity type semiconductor layer 120 may be lightly doped with an n-type dopants. The doping concentration of the first conductivity type semiconductor layer 120 may be lower than the doping concentration of the substrate 110. The doping type of the first conductivity type semiconductor layer 120 may be the same as the doping type of the substrate 110. The doping material of the first conductivity type semiconductor layer 120 may be the same as or different from the doping material of the substrate 110.

Next, a second conductivity type doping layer 133 may be formed in the upper region of the first conductivity type semiconductor layer 120. The second conductivity type doping layer 133 may be formed by an ion implantation process. The second conductivity type doping layer 133 may have a predetermined depth. At this time, the depth of the second conductivity type doping layer 133 may be determined by the number of ions implanted and/or the speed at which the ions are accelerated.

In an embodiment, the second conductivity type doping layer 133 may include SiC. For example, the second conductivity type doping layer 133 may include 4H SiC. The second conductivity type doping layer 133 may be doped with p type dopants. The second conductivity type doping layer 133 may be lightly doped with p type dopants. For example, the doping concentration of the second conductivity type doping layer 133 may be about 1.0×10¹⁷cm⁻³ or more and about 1.0×10¹⁹cm⁻³ or less. That is, the doping concentration of the second conductivity type doping layer 133 may be greater than or equal to 1.0×10¹⁷cm⁻³ and 1.0×10¹⁹cm⁻³ less than or equal to. The material, doping type, doping concentration, etc. of the second conductivity type doping layer 133 are not limited thereto and may be variously modified.

Next, ions may be implanted into the second conductivity type doping layer 133 so as to form the first conductivity type doped region 137. The first conductivity type doped region 137 may be formed within the second conductivity type doping layer 133 through an ion implantation process. A first conductivity type doped region 137 may be formed in at least a portion of the second conductivity type doping layer 133. First, a region in which the first conductivity type doped region 137 is to be formed may be defined on the second conductivity type doping layer 133 using a photolithography process. After this, the first conductivity type impurity ion may be implanted into the area. For example, the first conductivity type doped region 137 may be formed to a predetermined depth from the upper surface of the second conductivity type doping layer 133.

The first conductivity type doped region 137 may include SiC. For example, the first conductivity type doped region 137 may include 4H SiC. The first conductivity type doped region 137 may be highly doped with n-type. The doping type of the first conductivity type doped region 137 may be different from the doping type of the second conductivity type doping layer 133. The doping type of the first conductivity type doped region 137 may be the same as the doping type of the substrate 110 and the first conductivity type semiconductor layer 120. The doping concentration of the first conductivity type doped region 137 may be about 1.0×10¹⁸cm⁻³ or more and about 5.0×10²⁰cm⁻³ or less. The doping concentration of the first conductivity type doped region 137 may be greater than or equal to 1.0×10¹⁸cm⁻³ and less than or equal to 5.0×10²⁰cm⁻³. The material, doping type, doping concentration, etc. of the first conductivity type doped region 137 are not limited thereto and may be changed in various ways.

Subsequently, ions may be implanted into the second conductivity type doping layer 133 to further form the second conductivity type doped region 135. In an embodiment, the second conductivity type doped region 135 may be formed to be positioned at one side of the first conductivity type doped region 137. The second conductivity type doped region 135 may be formed so as to be alternately arranged along the first direction D1 with the first conductivity type doped region 137 on the second conductivity type doping layer 133.

First, a region in which the second conductivity type doped region 135 is to be formed may be defined on the second conductivity type doping layer 133 using a photolithography process. The region in which the second conductivity type doped region 135 is to be formed may be defined to be positioned at one side of the first conductivity type doped region 137. In an embodiment, the depth at which the second conductivity type doped region 135 is formed may be substantially the same as the depth of the first conductivity type doped region 137. At least a portion of both side surfaces of the second conductivity type doped region 135 may be surrounded by the first conductivity type doped region 137.

The second conductivity type doped region 135 may include SiC. For example, the second conductivity type doped region 135 may include 4H SiC. The second conductivity type doped region 135 may be heavily doped with p type dopants. The doping type of the second conductivity type doped region 135 may be the same as the doping type of the second conductivity type doping layer 133. The doping material of the second conductivity type doped region 135 may be the same as or different from the doping material of the second conductivity type doping layer 133. The doping concentration of the second conductivity type doped region 135 may be higher than the doping concentration of the second conductivity type doping layer 133.

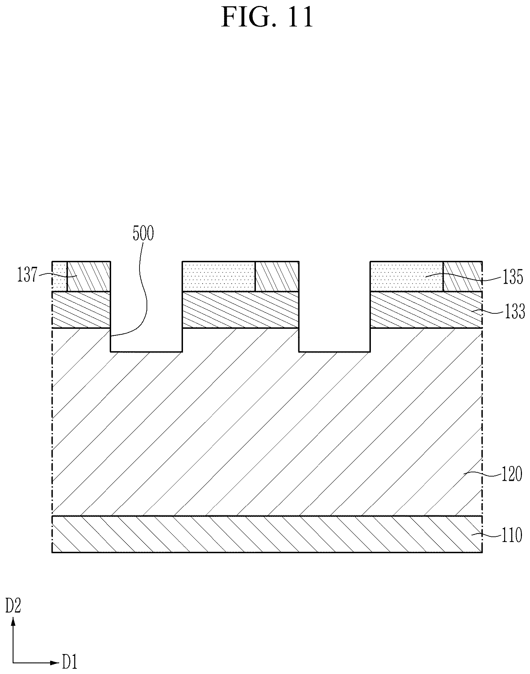

As illustrated in FIG. 11, a first trench 500 may be formed by etching portions of the first conductivity type semiconductor layer 120, portions of the second conductivity type doping layer 133, portions of the second conductivity type doped region 135, and portions of the first conductivity type doped region 137.

First, a mask pattern having an opening of a predetermined width may be formed over the first conductivity type doped region 137 and the second conductivity type doped region 135. At this time, the opening formed in the mask pattern may expose a portion of the first conductivity type doped region 137 and the second conductivity type doped region 135. Next, the first trench 500 may be formed by etching the first conductivity type doped region 137 and the second conductivity type doped region 135 exposed by a mask pattern, as well as portions of the second conductivity type doping layer 133 and the first conductivity type semiconductor layer 120 positioned thereunder. The first trench 500 may be removed by a dry etching process such as, for example, RIE (Reactive Ion Etching) or ICP (Inductively Coupled Plasma), but is not limited thereto.

In an embodiment, the first trench 500 may be formed to a predetermined depth. The first trench 500 may be formed in an approximately U-shape in cross section. The first trench 500 may include a bottom surface and two sidewalls extending from the bottom surface. The bottom surface of the first trench 500 may be defined by the first conductivity type semiconductor layer 120. One sidewall of the first trench 500 may be defined by the first conductivity type semiconductor layer 120, the second conductivity type doping layer 133, and the first conductivity type doped region 137. The other sidewall of the first trench 500, opposite to the one sidewall, may be defined by the first conductivity type semiconductor layer 120, the second conductivity type doping layer 133, and the second conductivity type doped region 135. The angle of the sidewalls relative to the bottom surface of the first trench 500 may be vertical, but is not limited thereto.

The lower surface of the first trench 500 may be positioned at a lower level than the lower surface of the second conductivity type doping layer 133. The lower surface of the first trench 500 may be positioned closer to the upper surface of the substrate 110 than the lower surface of the second conductivity type doping layer 133. That is, the distance between the lower surface of the first trench 500 and the upper surface of the substrate 110 may be shorter than the distance between the lower surface of the second conductivity type doping layer (133) and the upper surface of the substrate 110.

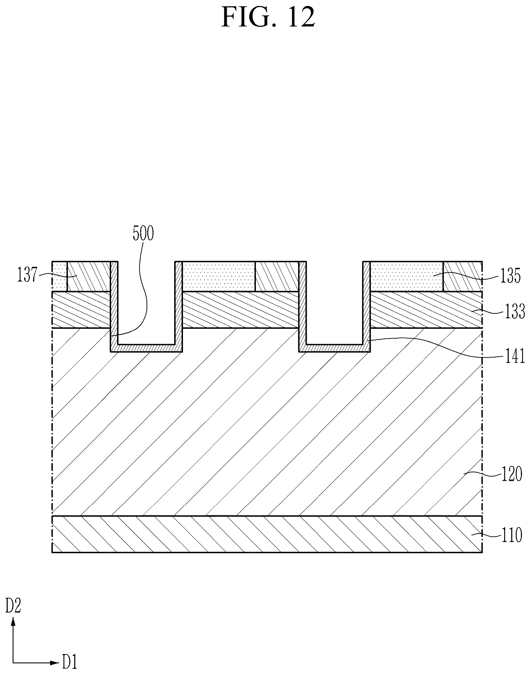

As illustrated in FIG. 12, a first gate insulating layer 141 may be conformally formed along the bottom surface and two sidewalls of the first trench 500. In an embodiment, the first gate insulating layer 141 may be formed by a high temperature oxidation process. The process of forming the first gate insulating layer 141 may be performed, for example, by a dry oxidation process. However, it is not limited thereto, and the process of forming the first gate insulating layer 141 may also be performed by a wet oxidation process. Through the oxidation process, the first gate insulating layer 141 may be formed on the surfaces of the first conductivity type semiconductor layer 120, the second conductivity type doping layer 133, the second conductivity type doped region 135, and the first conductivity type doped region 137 exposed in the first trench 500. In an embodiment, an oxide film may also be formed on the upper surfaces of the second conductivity type doped region 135 and the first conductivity type doped region 137. The oxide film formed on the upper surface of the second conductivity type doped region 135 and the first conductivity type doped region 137 may be removed, for example, by performing a chemical mechanical polishing (CMP) process.

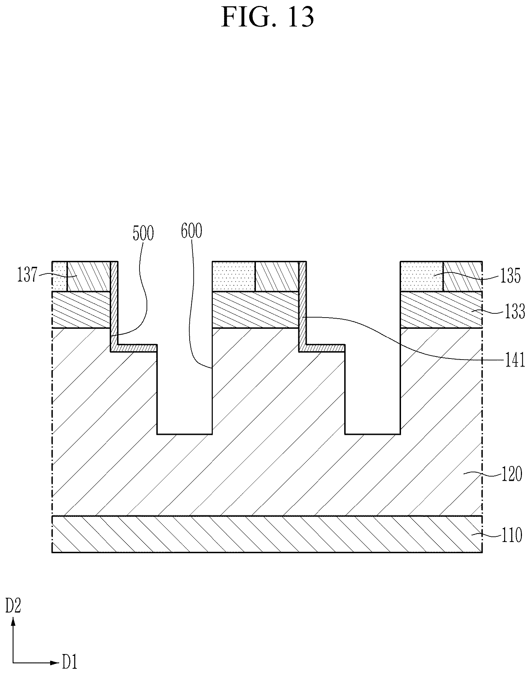

Next, as illustrated in FIG. 13, a portion of the first conductivity type semiconductor layer 120, a portion of the second conductivity type doping layer 133, a portion of the second conductivity type doped region 135, and a portion of the first gate insulating layer 141 may be etched so as to form a second trench 600. In the embodiment, a second trench 600 may be formed at one side of the first trench 500 so as to partially overlap with the first trench 500. During the process of forming the second trench 600, a portion of the first gate insulating layer 141 located on one of the sidewalls of the first trench 500 may be removed.

To form the second trench 600, a photolithography process may be performed once or twice or more. For example, a mask pattern that covers regions other than an area where the second trench 600 is to be formed and that includes an opening exposing the area where the second trench 600 is to be formed may first be formed on upper surfaces of the second conductivity type doped region 135 and the first conductivity type doped region 137. In the embodiment, the mask pattern may also be positioned on at least a portion of the inside of the first trench 500. The mask pattern may cover a portion of the first gate insulating layer 141 formed on the bottom surface of the first trench 500. The mask pattern may cover an area of the first gate insulating layer 141 formed on one sidewall of the first trench 500, which includes an area defined by the first conductivity type doped region 137. Thereafter, the second trench 600 may be formed by etching a portion of the first gate insulating layer 141 and a portion of the second conductivity type doped region 135 exposed by the mask pattern, as well as portions of the underlying second conductivity type doping layer 133 and the first conductivity type semiconductor layer 120. In the embodiment, the etching process of the first gate insulating layer 141, and the etching processes of the second conductivity type doped region 135, the second conductivity type doping layer 133, and the first conductivity type semiconductor layer 120 may be performed sequentially or simultaneously. The second trench 600 may be removed by a dry etching process such as, for example, RIE (Reactive Ion Etching) or ICP (Inductively Coupled Plasma), but is not limited thereto.

In an embodiment, the second trench 600 may be formed to a predetermined depth. The second trench 600 may be formed in an approximately U-shape in cross section. The second trench 600 may include a bottom surface and two sidewalls extending from the bottom surface. The bottom surface of the second trench 600 may be defined by the first conductivity type semiconductor layer 120. One sidewall of the second trench 600 may be defined by the first conductivity type semiconductor layer 120 and the first gate insulating layer 141. The other sidewall facing the one sidewall of the second trench 600 may be defined by the first conductivity type semiconductor layer 120, the second conductivity type doping layer 133, and the second conductivity type doped region 135. The angle of the sidewalls relative to the bottom surface of the second trench 600 may be vertical, but is not limited thereto.

In an embodiment, the lower surface of the second trench 600 may be positioned at a lower level than the lower surface of the first trench 500. The lower surface of the second trench 600 may be positioned closer to the upper surface of the substrate 110 than the lower surface of the first trench 500. In an embodiment, the distance between the level at which the lower surface of the second trench 600 is positioned and the level at which the lower surface of the lower surface of the first conductivity type semiconductor layer 120 is positioned may be shorter than the distance between the level at which the lower surface of the second trench 600 is positioned and the level at which the upper surface of the first conductivity type semiconductor layer 120 is positioned.

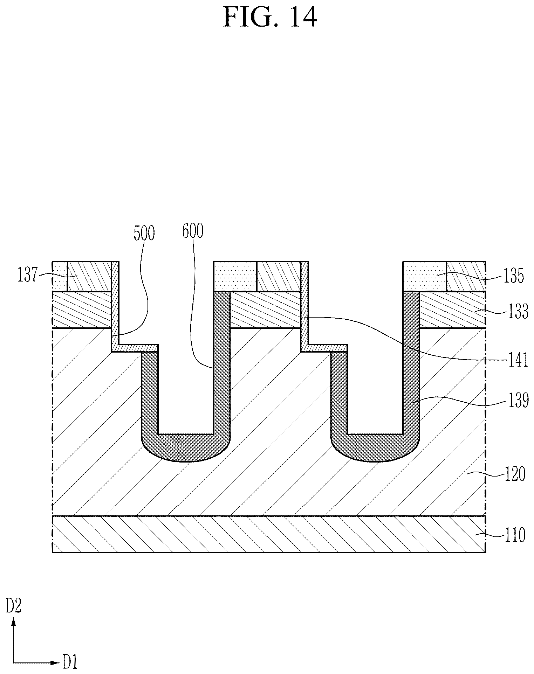

Next, as illustrated in FIG. 14, a shielding pattern 139 may be formed around the bottom surface and sidewalls of the second trench 600. Referring to FIG. 14, the shielding pattern 139 may be formed from the bottom surface of the second trench 600 toward the first conductivity type semiconductor layer 120. The shielding pattern 139 may be formed from both sidewalls of the second trench 600 toward the first conductivity type semiconductor layer 120.

In an embodiment, the shielding pattern 139 may be formed by an ion implantation process. For example, p type impurities may be implanted into the bottom surface and both sidewalls of the second trench 600 by an ion implantation process, thereby forming a shielding pattern 139 having a predetermined depth toward the first conductivity type semiconductor layer 120 from the bottom surface and both sidewalls of the second trench 600.

The shielding pattern 139 may include SiC. For example, the shielding pattern 139 may include 4H SiC. In an embodiment, the shielding pattern 139 may have a different conductivity type than the first conductivity type semiconductor layer 120. In an embodiment, the shielding pattern 139 may be doped at a relatively high concentration compared to the first conductivity type semiconductor layer 120. In an embodiment, the shielding pattern 139 may have a higher doping concentration than the first conductivity type semiconductor layer 120. In an embodiment, the doping concentration of the shielding pattern 139 may be higher than the doping concentration of the second conductivity type doping layer 133. In an embodiment, the doping concentration of the shielding pattern 139 may be substantially the same as or lower than the doping concentration of the second conductivity type doped region 135, but is not limited thereto.

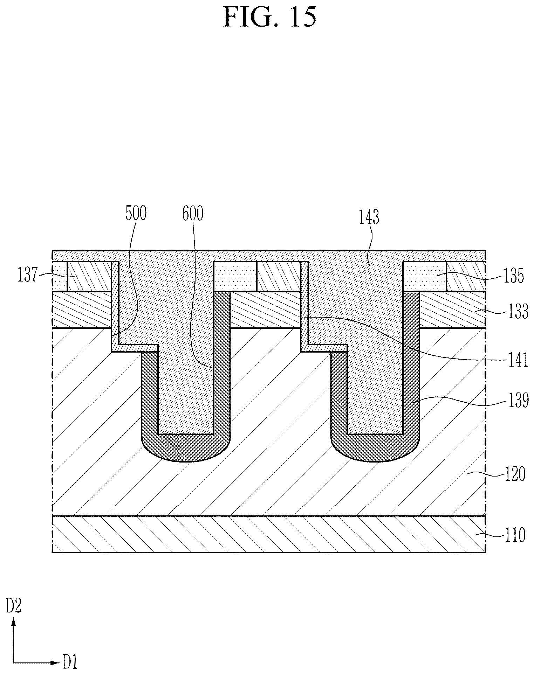

As illustrated in FIG. 15, an internal insulating pattern 143 may be formed to fill the interior of the second trench 600. The internal insulating pattern 143 may also be formed inside the first trench 500. The internal insulating pattern 143 may also be formed on the upper surface of the first conductivity type doped region 137, the upper surface of the second conductivity type doped region 135, and the upper surface of the first gate insulating layer 141. The internal insulating pattern 143 may include an insulating material. The internal insulating pattern 143 may include the same insulating material as the first gate insulating layer 141. For example, the internal insulating pattern 143 may include silicon oxide (SiO₂), but is not limited there to.

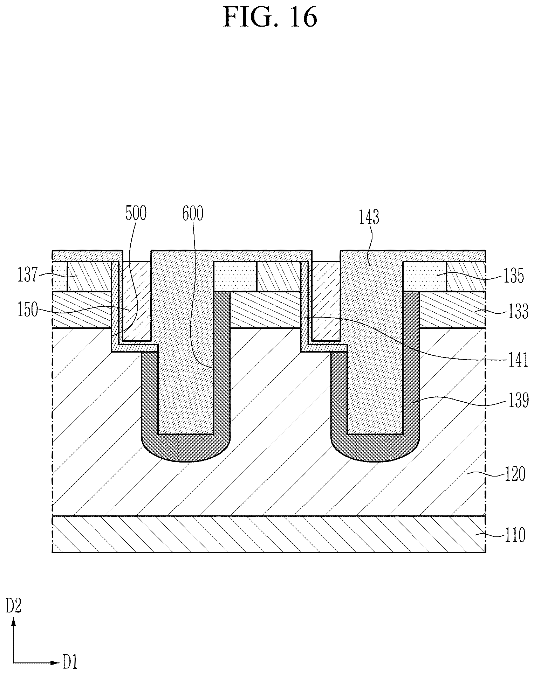

Next, as illustrated in FIG. 16, the gate electrode 150 may be formed in a portion inside the first trench 500. First, a portion of the internal insulating pattern 143 filling the inside of the first trench 500 is etched, and then a conductive material (e.g., polysilicon doped with impurities) is deposited on the etched portion so as to form a gate electrode 150. At this time, a second gate insulating layer 144 (see FIG. 2) may be formed between the gate electrode 150 and the first gate insulating layer 141.

In one embodiment, the gate electrode 150 may be formed by depositing polysilicon over the entire upper surface of the semiconductor device according to the embodiment, and then removing the conductive material positioned over regions other than the etched region through an etch-back process. A portion of the first internal insulating pattern 143a and the second internal insulating pattern 143b positioned at a level higher than the upper surface of the second conductivity type doped region 135 and the first conductivity type doped region 137 may be removed (e.g., through a chemical mechanical polishing process).

In another embodiment, the gate electrode 150 may be formed by depositing a conductive material over the entire upper surface of the semiconductor device according to the embodiment, and then removing the conductive material positioned above the level of the upper surfaces of the second conductivity type doped region 135 and the first conductivity type doped region 137 through a chemical mechanical polishing (CMP) process. At this time, a portion of the internal insulating pattern 143 positioned at a level higher than the upper surface of the second conductivity type doped region 135 and the first conductivity type doped region 137 may be removed together.

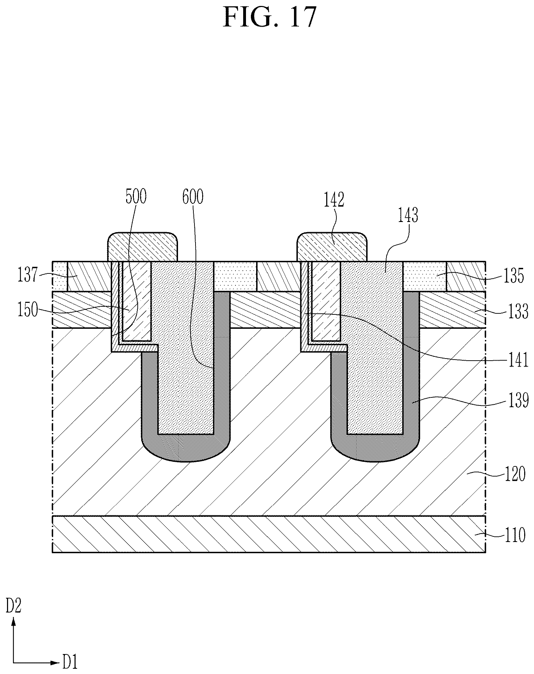

Next, as illustrated in FIG. 17, a capping layer 142 covering the upper surface of the gate electrode 150 may be formed. First, a portion of the internal insulating pattern 143 positioned at a level higher than the upper surface of the gate electrode 150 may be removed by a chemical mechanical polishing process. Next, an insulating material may be deposited on the upper surface of the gate electrode 150, the first gate insulating layer 141, the second conductivity type doped region 135, the first conductivity type doped region 137, and the internal insulating pattern 143, and then patterned so as to form a capping layer 142. The capping layer 142 may cover the upper surface of the gate electrode 150. The capping layer 142 may cover at least a portion of the first gate insulating layer 141, the first conductivity type doped region 137, and the internal insulating pattern 143 adjacent to the gate electrode 150.

The capping layer 142 may include an insulating material. For example, the capping layer 142 may include silicon oxide (SiO₂). However, it is not limited to this, and the material of the capping layer 142 may be changed in various ways. As another example, the capping layer 142 may include SiN, SiON, SiC, SiCN, or a combination thereof. The method and material for forming the capping layer 142 are not limited thereto and may be variously modified.

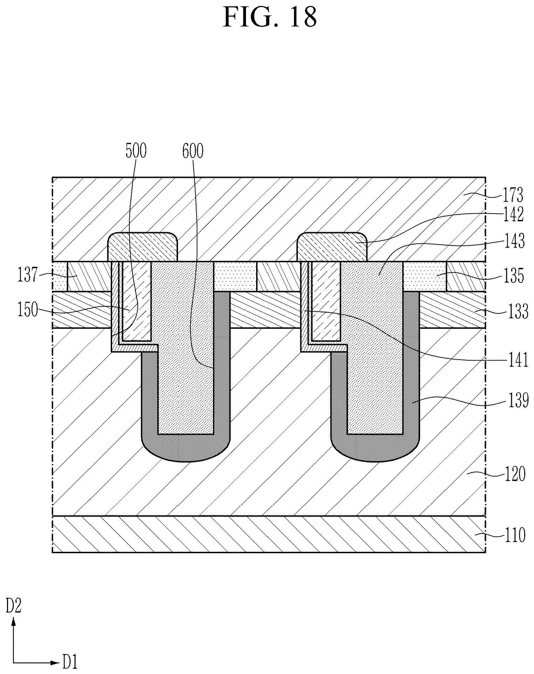

Next, as illustrated in FIG. 18, a source electrode 173 may be formed. Specifically, a conductive material may be deposited on the second conductivity type doped region 135, the first conductivity type doped region 137, the internal insulating pattern 143, and the capping layer 142 to form a source electrode 173. The source electrode 173 may be electrically insulated from the gate electrode 150 by the capping layer 142. The source electrode 173 may be in contact with at least a portion of the upper surface of the second conductivity type doped region 135, the first conductivity type doped region 137, and the internal insulating pattern 143.

Next, a conductive material may be deposited on the second surface, i.e., the lower surface, of the substrate 110 to form a drain electrode 175 (see FIG. 1). The drain electrode 175 may be in contact with the substrate 110.

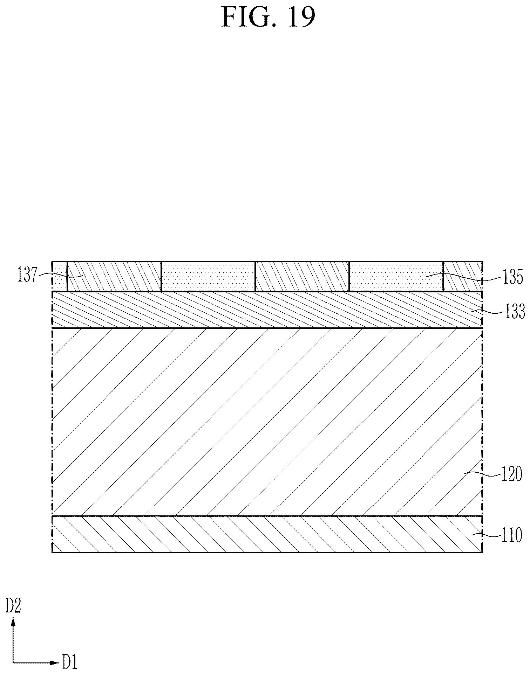

FIG. 19 to FIG. 27 are process cross-sectional views for explaining a manufacturing process of a semiconductor device according to an embodiment. Specifically, FIG. 19 to FIG. 27 are process cross-sectional views for explaining the manufacturing process of the semiconductor device described with reference to FIG. 3 and FIG. 4. In the following, redundant descriptions of the manufacturing process already described with reference to FIG. 10 to FIG. 18 will be omitted, and the focus will be placed on the differences.

As illustrated in FIG. 19, a second conductivity type doping layer 133, a first conductivity type doped region 137, and a second conductivity type doped region 135 may be sequentially formed on top of a first conductivity type semiconductor layer 120 positioned on a substrate 110.

First, a first conductivity type semiconductor layer 120 may be formed on the first surface, i.e., the upper surface, of the substrate 110 using an epitaxial growth method. The doping material of the first conductivity type semiconductor layer 120 may be the same as or different from the doping material of the substrate 110.

Next, a second conductivity type doping layer 133 may be formed in the upper region of the first conductivity type semiconductor layer 120. The second conductivity type doping layer 133 may be formed by an ion implantation process. The second conductivity type doping layer 133 may have a predetermined depth. At this time, the depth of the second conductivity type doping layer 133 may be determined by the number of ions implanted and/or the speed at which the ions are accelerated.

Next, ions may be implanted into the second conductivity type doping layer 133 so as to form a first conductivity type doped region 137. The first conductivity type doped region 137 may be formed within the second conductivity type doping layer 133 through an ion implantation process. A first conductivity type doped region 137 may be formed in at least a portion of the second conductivity type doping layer 133. For example, the first conductivity type doped region 137 may be formed to a predetermined depth from the upper surface of the second conductivity type doping layer 133.

Next, ions may be implanted into the second conductivity type doping layer 133 to further form a second conductivity type doped region 135. In an embodiment, the second conductivity type doped region 135 may be formed to be positioned at one side of the first conductivity type doped region 137. The second conductivity type doped region 135 may be formed on the second conductivity type doping layer 133 to be alternately arranged with the first conductivity type doped region 137 along a first direction D1.

In an embodiment, the depth at which the second conductivity type doped region 135 is formed may be substantially the same as the depth of the first conductivity type doped region 137. At least a portion of both side surfaces of the second conductivity type doped region 135 may be surrounded by the first conductivity type doped region 137.

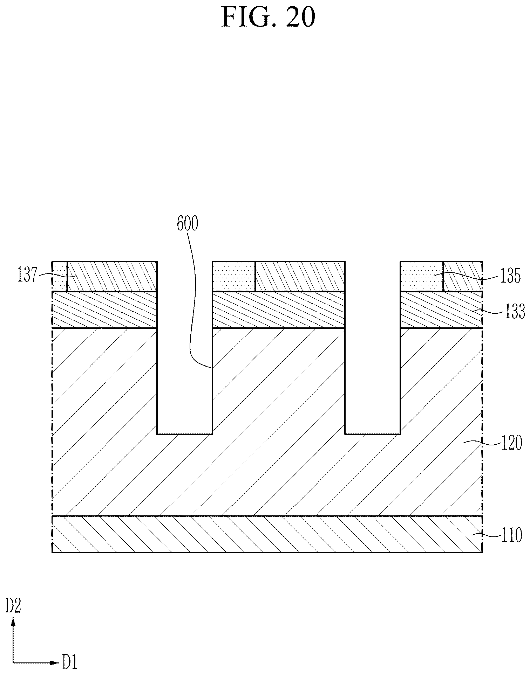

As illustrated in FIG. 20, second trench 600 may be formed by etching a portion of the first conductivity type semiconductor layer 120, a portion of the second conductivity type doping layer 133, a portion of the second conductivity type doped region 135, and a portion of the first conductivity type doped region 137.

First, a mask pattern including an opening having a predetermined width may be formed on the first conductivity type doped region 137 and the second conductivity type doped region 135. At this time, the opening formed in the mask pattern may expose a portion of the first conductivity type doped region 137 and a portion of the second conductivity type doped region 135. Next, a second trench 600 may be formed by etching the first conductivity type doped region 137 and the second conductivity type doped region 135 exposed by the mask pattern, as well as portions of the underlying second conductivity type doping layer 133 and the first conductivity type semiconductor layer 120. The second trench 600 may be removed by a dry etching process such as, for example, RIE (Reactive Ion Etching) or ICP (Inductively Coupled Plasma), but is not limited thereto.

In an embodiment, the second trench 600 may be formed to a predetermined depth. The second trench 600 may be formed in an approximately U-shape in cross section. The second trench 600 may include a bottom surface and two sidewalls extending from the bottom surface. The bottom surface of the second trench 600 may be defined by the first conductivity type semiconductor layer 120. One sidewall of the second trench 600 may be defined by the first conductivity type semiconductor layer 120, the second conductivity type doping layer 133, and the first conductivity type doped region 137. The other sidewall of the second trench 600, opposite to the one sidewall, may be defined by the first conductivity type semiconductor layer 120, the second conductivity type doping layer 133, and the second conductivity type doped region 135.

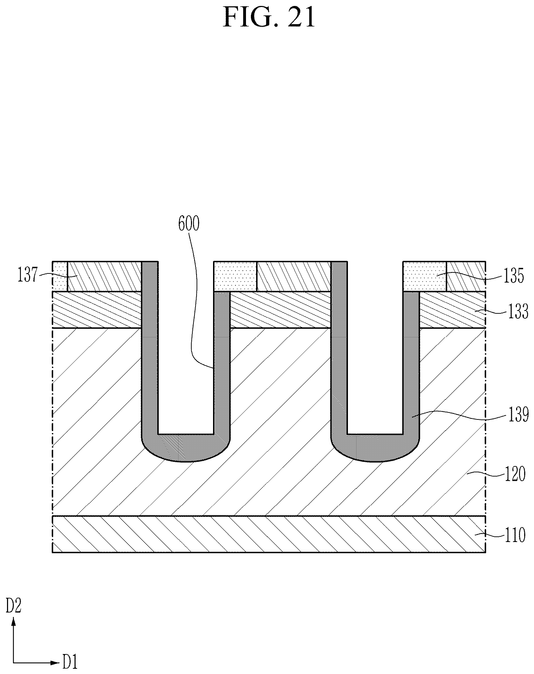

Next, as illustrated in FIG. 21, a shielding pattern 139 may be formed around the bottom surface and sidewalls of the second trench 600. Referring to FIG. 21, the shielding pattern 139 may be formed from the bottom surface of the second trench 600 toward the first conductivity type semiconductor layer 120. The shielding pattern 139 may be formed from both sidewalls of the second trench 600 toward the first conductivity type semiconductor layer 120, the second conductivity type doping layer 133, and/or the first conductivity type doped region 137.

In an embodiment, the shielding pattern 139 may be formed by an ion implantation process. In an embodiment, the shielding pattern 139 may be doped at a relatively high concentration compared to the first conductivity type semiconductor layer 120. That is, the shielding pattern 139 may have a higher doping concentration than the first conductivity type semiconductor layer 120. In an embodiment, the doping concentration of the shielding pattern 139 may be higher than the doping concentration of the second conductivity type doping layer 133. In an embodiment, the doping concentration of the shielding pattern 139 may be substantially equal to or lower than the doping concentration of the second conductivity type doped region 135, but is not limited thereto.

As shown in FIG. 22, a first internal insulating pattern 143a may be formed to fill the inside of the second trench 600. The first internal insulating pattern 143a may also be formed on the upper surface of the first conductivity type doped region 137, the upper surface of the second conductivity type doped region 135, and the upper surface of the shielding pattern 139. The first internal insulating pattern 143a may include an insulating material. The first internal insulating pattern 143a may include the same insulating material as the first gate insulating layer 141. For example, the first internal insulating pattern 143a may include silicon oxide (SiO₂), but it is not limited thereto.

Next, as illustrated in FIG. 23, a first trench 500 may be formed by etching a portion of the first conductivity type semiconductor layer 120, a portion of the second conductivity type doping layer 133, a portion of the first conductivity type doped region 137, a portion of the shielding pattern 139, and a portion of the first internal insulating pattern 143a. In the embodiment, the first trench 500 may be formed at one side of the second trench 600 so as to partially overlap with the second trench 600. For example, the first trench 500 may be formed at one side of the second trench 600 so as to partially overlap with the second trench 600 in a first direction D1.

To form the first trench 500, a photolithography process may be performed once or twice or more. For example, a mask pattern including an opening that exposes a region in which the first trench 500 is to be formed may first be formed on the upper surface of the first internal insulating pattern 143a. Thereafter, a first trench 500 may be formed by etching a portion of the first internal insulating pattern 143a exposed by the mask pattern, as well as portions of the underlying first conductivity type doped region 137, the second conductivity type doping layer 133, and the shielding pattern 139. In an embodiment, the process of etching the first internal insulating pattern 143a and the process of etching the first conductivity type doped region 137, the second conductivity type doping layer 133, the shielding pattern 139, and the first conductivity type semiconductor layer 120 may be performed sequentially or simultaneously. The first trench 500 may be formed by a dry etching process, such as reactive ion etching (RIE) or inductively coupled plasma (ICP), but is not limited thereto.

In an embodiment, the first trench 500 may be formed to a predetermined depth. The first trench 500 may have a substantially U-shaped profile in cross section. The first trench 500 may include a bottom surface and two sidewalls extending from the bottom surface. The bottom surface of the first trench 500 may be defined by a first conductivity type semiconductor layer 120, a shielding pattern 139, and a first internal insulating pattern 143a. One sidewall of the first trench 500 may be defined by the first conductivity type semiconductor layer 120, the second conductivity type doping layer 133, the first conductivity type doped region 137, and the first internal insulating pattern 143a. The other sidewall of the first trench 500, opposite to the one sidewall, may be defined by the first internal insulating pattern 143a.

Referring to FIG. 23, the first trench 500 may have a rectangular shape in cross section with a uniform width in a first direction D1.

In another embodiment, unlike what is illustrated in FIG. 23, at least one of the sidewalls of the first trench 500 may be inclined. For example, the width of the first trench 500 may gradually decrease from top to bottom in the first direction D1. In the embodiment, one of the two sidewalls of the first trench 500, the entire area of which is defined by the first internal insulating pattern 143a, may extend in a diagonal direction between a first direction D1 and a second direction D2. In the embodiment, another sidewall of the first trench 500, defined by the first conductivity type semiconductor layer 120, the second conductivity type doping layer 133, and the first conductivity type doped region 137, may extend in a direction parallel to the second direction D2. This may be due to a difference in etch selectivity between silicon carbide (SiC), which is included in the first conductivity type doped region 137, the second conductivity type doping layer 133, the first conductivity type semiconductor layer 120, and the shielding pattern 139, and silicon oxide (SiO₂), which is included in the internal insulating pattern 143, during the process of forming the first trench 500. In this case, if the gate electrode 150 is formed directly inside the first trench 500 without the process of forming the second internal insulating pattern 143b to be described later, the gate electrode 150 having a shape as described with reference to FIG. 8 may be formed.

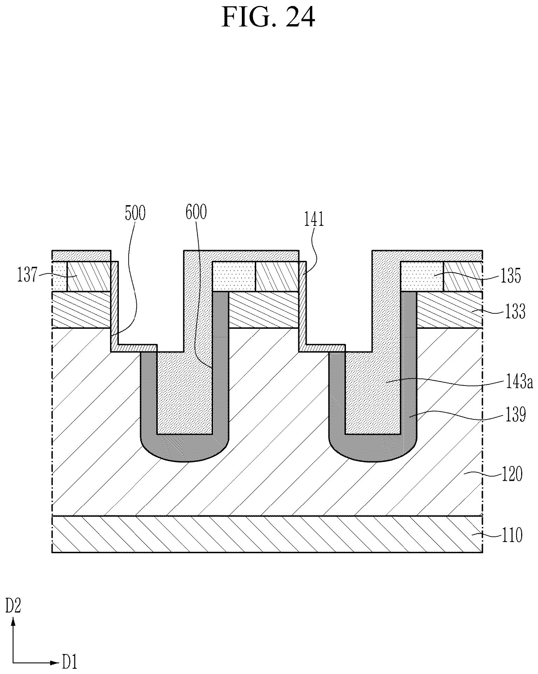

Next, as illustrated in FIG. 24, a first gate insulating layer 141 may be formed along at least a portion of the bottom surface and one sidewall of the first trench 500. In an embodiment, the first gate insulating layer 141 may be formed only on the first conductivity type doped region 137, the second conductivity type doping layer 133, the first conductivity type semiconductor layer 120, and the shielding pattern 139 among the entire areas of the bottom surface and inner sidewalls of the first trench 500. This may be attributed to a characteristic of the process in which the first gate insulating layer 141 is formed by an oxidation process. For example, the process of forming the first gate insulating layer 141 may be performed by a dry oxidation process. However, it is not limited thereto, and the process of forming the first gate insulating layer 141 may also be performed by a wet oxidation process.

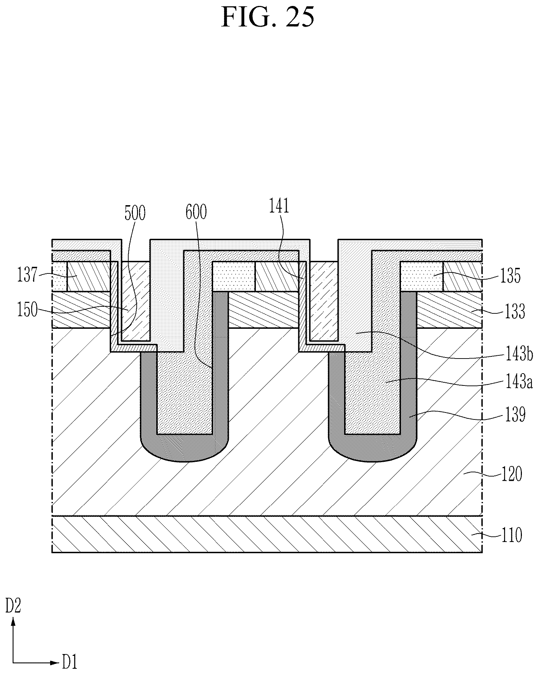

As illustrated in FIG. 25, a gate electrode 150 may be formed in some area inside the first trench 500. First, a second internal insulating pattern 143b may be formed to fill the inside of the first trench 500. The second internal insulating pattern 143b may be formed on the entire upper surface of the semiconductor device according to the embodiment. For example, as illustrated in FIG. 25, the second internal insulating pattern 143b may also be formed on the upper surface of the first internal insulating pattern 143a positioned outside the first trench 500.

Next, after etching a portion of the second internal insulating pattern 143b, a conductive material (e.g., polysilicon doped with impurities) may be deposited on the etched portion to form a gate electrode 150. At this time, a second gate insulating layer 144 (see FIG. 4) may be formed between the gate electrode 150 and the first gate insulating layer 141.

The gate electrode 150 may be formed, for example, by depositing polysilicon over the entire upper surface of the semiconductor device according to the embodiment, and then removing the conductive material located over regions other than the etched region through an etch-back process. A portion of the first internal insulating pattern 143a and the second internal insulating pattern 143b positioned at a level higher than the upper surface of the second conductivity type doped region 135 and the first conductivity type doped region 137 may be removed (e.g., through a chemical mechanical polishing process).

In another embodiment, the gate electrode 150 may be formed by depositing a conductive material over the entire upper surface of the semiconductor device according to the embodiment, and then removing the conductive material located above the level of the upper surfaces of the second conductivity type doped region 135 and the first conductivity type doped region 137 through a chemical mechanical polishing (CMP) process. At this time, a portion of the first internal insulating pattern 143a and the second internal insulating pattern 143b positioned at a level higher than the upper surface of the second conductivity type doped region 135 and the first conductivity type doped region 137 may be removed together.

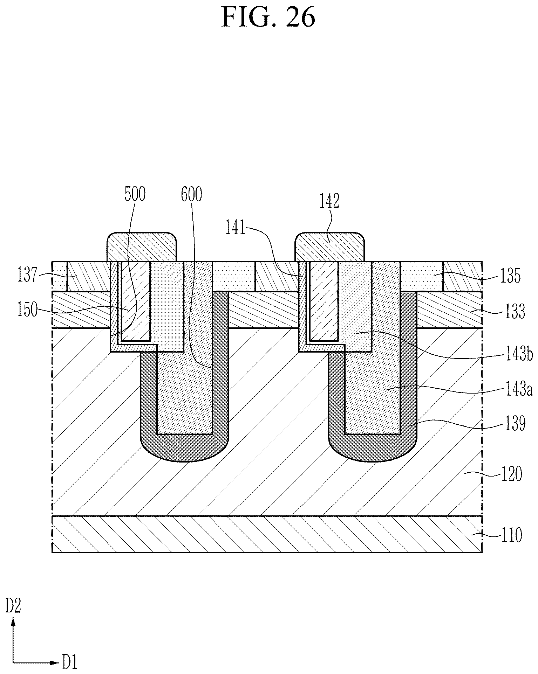

As illustrated in FIG. 26, a capping layer 142 covering the upper surface of the gate electrode 150 may be formed. First, a portion of the first internal insulating pattern 143a and the second internal insulating pattern 143b positioned at a level higher than the upper surface of the gate electrode 150 may be removed by a chemical mechanical polishing process. Next, an insulating material may be deposited over the upper surfaces of the gate electrode 150, the first gate insulating layer 141, the second conductivity type doped region 135, the first conductivity type doped region 137, and the internal insulating pattern 143, and then patterned to form a capping layer 142. The capping layer 142 may cover the upper surface of the gate electrode 150. The capping layer 142 may cover at least a portion of the first gate insulating layer 141, the first conductivity type doped region 137, and the second internal insulating pattern 143b adjacent to the gate electrode 150.

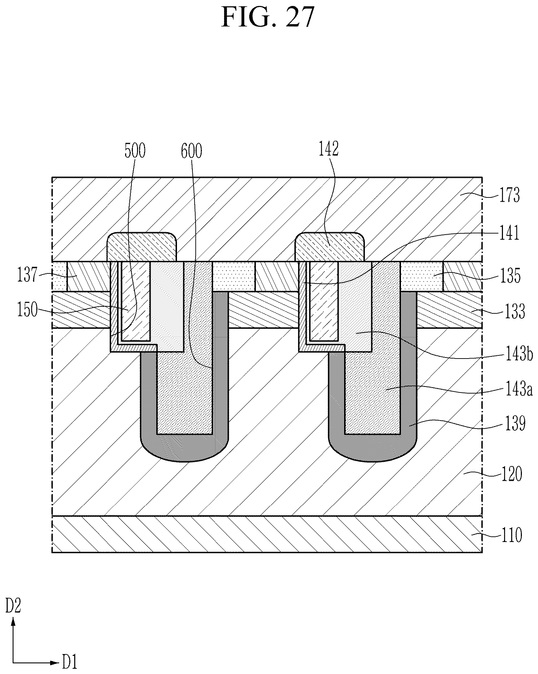

Next, as illustrated in FIG. 27, a source electrode 173 may be formed. Specifically, a conductive material may be deposited on the second conductivity type doped region 135, the first conductivity type doped region 137, the internal insulating pattern 143, and the capping layer 142 to form a source electrode 173. Next, a conductive material may be deposited on the second surface, i.e., the lower surface, of the substrate 110 to form a drain electrode 175 (see FIG. 3). The drain electrode 175 may be in contact with the substrate 110.

A method for manufacturing a semiconductor device according to an embodiment includes forming a first conductivity type semiconductor layer on a first surface of a substrate, forming a second conductivity type doping layer on the first conductivity type semiconductor layer, forming a first conductivity type doped region on the second conductivity type doping layer, forming a first trench by etching portions of the first conductivity type doped region, the second conductivity type doping layer, and the first conductivity type semiconductor layer, forming a first gate insulating layer on a bottom surface and a side surface of the first trench, forming a second trench located at one side of the first trench and overlapping the first trench, forming a shielding pattern around the second trench, forming a gate electrode including a first side surface and a second side surface opposite to the first side surface within the first trench, forming a source electrode on the first conductivity type doped region, and forming a drain electrode on the second surface of the substrate. The first gate insulating layer is positioned on the first side surface of the gate electrode and the lower surface of the gate electrode, the second conductivity type doping layer covers at least a portion of a side surface of the first gate insulating layer, and the first conductivity type doped region covers at least another portion of a side surface of the first gate insulating layer.

A method for manufacturing a semiconductor device according to an embodiment further includes filling an internal insulating pattern within the second trench. The shielding pattern surrounds at least a portion of a side surface and a lower surface of the internal insulating pattern.

In a method for manufacturing a semiconductor device according to an embodiment, the forming the second trench includes forming the second trench such that a bottom surface of the second trench is positioned closer to an upper surface of the substrate compared to a bottom surface of the first trench.

In a method for manufacturing a semiconductor device according to an embodiment, the forming the first gate insulating layer includes forming the first gate insulating layer on a bottom surface and two side surfaces of the first trench, and in the forming the second trench, the first gate insulating layer formed on one of the two side surfaces of the first trench is removed.

In a method for manufacturing a semiconductor device according to an embodiment, the shielding pattern covers a portion of a lower surface of the first gate insulating layer positioned on the bottom surface of the first trench.

In a method for manufacturing a semiconductor device according to an embodiment, the forming the gate electrode includes forming the gate electrode such that the first side of the gate electrode and lower surface of the gate electrode are in contact with the first gate insulating layer.

The method for manufacturing a semiconductor device according to the embodiment further includes forming a dummy semiconductor pattern inside the second trench.

In a method for manufacturing a semiconductor device according to an embodiment, forming the dummy semiconductor pattern includes removing a portion of an internal insulating pattern located inside the second trench, and filling the removed portion of the internal insulating pattern with a semiconductor material.

In a method for manufacturing a semiconductor device according to an embodiment, the dummy semiconductor pattern includes polysilicon doped with impurities.

In a method for manufacturing a semiconductor device according to an embodiment, the shielding pattern is doped with a p-type impurity.

Embodiments are set out in the following Clauses:
Clause 1. A semiconductor device comprising:
   a substrate;
   a first conductivity type semiconductor layer on a first surface of the substrate;
   a first trench and a second trench overlapping the first trench, the second trench being positioned at one side of the first trench, and the first trench and the second trench each penetrating in the first conductivity type semiconductor layer;
   a gate electrode in the first trench and including a first side surface and a second side surface opposing the first side surface;
   a first gate insulating layer on the first side surface and a lower surface of the gate electrode;
   a second conductivity type doping layer on the first conductivity type semiconductor layer and covering at least a portion of a side surface of the first gate insulating layer;
   a first conductivity type doped region on the second conductivity type doping layer and covering at least another portion of the side surface of the first gate insulating layer;
   a source electrode on the first conductivity type doped region;
   a drain electrode on a second surface of the substrate;
   an internal insulating pattern in the second trench;
   wherein a bottom surface of the second trench is positioned closer to the drain electrode than a bottom surface of the first trench; and
   wherein the internal insulating pattern comprises silicon oxide (SiO₂).
Clause 2. The semiconductor device of Clause 1, further comprising:
   a shielding pattern surrounding at least a portion of a side surface and a lower surface of the internal insulating pattern.
Clause 3. The semiconductor device of Clause 1 or Clause 2, further comprising:
   a second gate insulating layer between the gate electrode and the first gate insulating layer.
Clause 4. The semiconductor device of any of Clauses 1-3, further comprising:
   a dummy semiconductor pattern in the second trench.
Clause 5. A semiconductor device comprising:
   a substrate;
   a first conductivity type semiconductor layer on a first surface of the substrate;
   a first trench and a second trench overlapping the first trench, the second trench being positioned at one side of the first trench, and the first trench and the second trench each penetrating in the first conductivity type semiconductor layer;
   a gate electrode in the first trench and including a first side surface and a second side surface opposing the first side surface;
   a first gate insulating layer conformally on a bottom surface of the first trench, and on a side surface of the first trench facing the first side surface of the gate electrode;
   an internal insulating pattern in the second trench having an upper surface at a same level as an upper surface of the gate electrode;
   a capping layer covering the upper surface of the gate electrode and the internal insulating pattern;
   a second conductivity type doping layer on the first conductivity type semiconductor layer and covering at least a portion of a side surface of the first gate insulating layer and a portion of a side surface of the internal insulating pattern;
   a first conductivity type doped region on the second conductivity type doping layer and covering at least another portion of the side surface of the first gate insulating layer;
   a second conductivity type doped region on the second conductivity type doping layer and covering at least a portion of the side surface of the internal insulating pattern;
   a source electrode covering at least a portion of an upper surface of the first conductivity type doped region, an upper surface of the second conductivity type doped region, an upper surface of the internal insulating pattern, and an upper surface and a side surface of the capping layer;
   a drain electrode on a second surface of the substrate; and
   a shielding pattern surrounding at least another portion of the side surface and a lower surface of the internal insulating pattern,
   wherein at least a portion of a lower surface of the first gate insulating layer and a lower surface of the second conductivity type doped region are in contact with the shielding pattern, and
   wherein the internal insulating pattern comprises silicon oxide (SiO₂).

Although the embodiments of the present disclosure have been described in detail above, the scope of the present disclosure is not limited thereto, and various modifications and improvements made by those skilled in the art using the basic concept of the present disclosure defined in the following claims also fall within the scope of the present disclosure.

## Claims

1. A semiconductor device comprising:
a substrate (110);
a first conductivity type semiconductor layer (120) on a first surface of the substrate (110);
a first trench (500) and a second trench (600) overlapping the first trench (500), the second trench (600) being positioned at one side of the first trench (500), and the first trench (500) and the second trench (600) each penetrating in the first conductivity type semiconductor layer (120);
a gate electrode (150) in the first trench (500) and including a first side surface and a second side surface opposing the first side surface;
a first gate insulating layer (141) on the first side surface and a lower surface of the gate electrode (150);
a second conductivity type doping layer (133) on the first conductivity type semiconductor layer (120) and covering at least a portion of a side surface of the first gate insulating layer (141);
a first conductivity type doped region (137) on the second conductivity type doping layer (133) and covering at least another portion of the side surface of the first gate insulating layer (141);
a source electrode (173) on the first conductivity type doped region (137);
a drain electrode (175) on a second surface of the substrate (110); and
a shielding pattern (139) around the second trench (600).

2. The semiconductor device of claim 1,
wherein a bottom surface of the second trench (600) is positioned closer to the drain electrode (175) than a bottom surface of the first trench (500).

3. The semiconductor device of claim 1 or claim 2,
wherein the first gate insulating layer (141) is on a bottom surface and a sidewall of the first trench (500), the sidewall of the first trench (500) facing the first side surface of the gate electrode (150).

4. The semiconductor device of claim 3,
wherein the shielding pattern (139) covers a portion of a lower surface of the first gate insulating layer (141) on the bottom surface of the first trench (500).

5. The semiconductor device of any preceding claim,
wherein among the first side surface and the second side of the gate electrode (150), the first gate insulating layer (141) is disposed on only the first side surface of the gate electrode (150).

6. The semiconductor device of any preceding claim, further comprising:
an internal insulating pattern (143) in the second trench (600),
wherein the shielding pattern (139) surrounds at least a portion of a side surface and a lower surface of the internal insulating pattern (143).

7. The semiconductor device of claim 6,
wherein the internal insulating pattern (143) includes silicon oxide.

8. The semiconductor device of claim 6 or claim 7, further comprising:
a second gate insulating layer (144) between the gate electrode (150) and the first gate insulating layer (141).

9. The semiconductor device of claim 8,
wherein the second gate insulating layer (144) includes a portion between the second side surface of the gate electrode (150) and the internal insulating pattern (143).

10. The semiconductor device of claim 8 or claim 9,
wherein the internal insulating pattern (143) and the second gate insulating layer (144) include the same insulating material.

11. The semiconductor device of any of claims 8-10,
wherein the first gate insulating layer (141) and the second gate insulating layer (144) comprise different insulating materials.

12. The semiconductor device of any preceding of claims 1-7,
wherein the first side surface and the lower surface of the gate electrode (150) are in contact with the first gate insulating layer (141).

13. The semiconductor device of any preceding claim, further comprising: a dummy semiconductor pattern (138) in the second trench (600).

14. The semiconductor device of claim 13, further comprising:
an internal insulating pattern (143) in the second trench (600),
wherein the internal insulating pattern (143) surrounds a side surface and a lower surface of the dummy semiconductor pattern (138).

15. The semiconductor device of any preceding claim,
wherein the shielding pattern (139) is doped with a p-type impurity.
